(19) **Europäisches Patentamt / European Patent Office / Office européen des brevets**

(11) **EP 1 928 016 B1**

(12) **EUROPEAN PATENT SPECIFICATION**

(45) Date of publication and mention
of the grant of the patent:
**06.01.2010 Bulletin 2010/01**

(51) Int Cl.:
***H01L 21/322*** (2006.01)

(21) Application number: **07021650.2**

(22) Date of filing: **07.11.2007**

(54) **Silicon wafer and method for manufacturing the same**

Silicium-Wafer und dessen Herstellungsmethode

Plaquette de silicium et sa méthode de fabrication

(84) Designated Contracting States:
**DE**

(30) Priority: **01.12.2006 JP 2006326225**
**07.12.2006 JP 2006330914**

(43) Date of publication of application:
**04.06.2008 Bulletin 2008/23**

(73) Proprietor: **Siltronic AG**
**81737 München (DE)**

(72) Inventors:
• **Nakai, Katsuhiko Dr.**
**Yamaguchi 743-0071 (JP)**
• **Fukushima, Sei Dr.**
**Kanagawa 243-0812 (JP)**

(74) Representative: **Baar, Christian et al**
**c/o Siltronic AG**
**Corporate Intellectual Property**
**Hanns-Seidel-Platz 4**
**81737 München (DE)**

(56) References cited:
EP-A- 0 090 320     EP-A- 1 313 137
EP-A- 1 408 540     EP-A- 1 420 440
WO-A-2006/003812    JP-A- 8 213 403
JP-A- 2006 040 980  US-A1- 2003 203 519

• SUEOKA K ET AL: "EFFECT OF OXIDE PRECIPITATES SIZES ON THE MECHANICAL STRENGTH OF CZOCHRALSKI SILICON WAFERS" JAPANESE JOURNAL OF APPLIED PHYSICS, JAPAN SOCIETY OF APPLIED PHYSICS, TOKYO, JP, vol. 36, no. 12A, PART 1, December 1997 (1997-12), pages 7095-7099, XP001110829 ISSN: 0021-4922
• SUOEKA, K. ET AL: "Dependence of Mechanical Strength of Czochralski Silicon Wafers on the Temperature of Oxygen Precipitation Annealing" JOURNAL OF THE ELECTROCHEMICAL SOCIETY, vol. 144, no. 3, March 1997 (1997-03), pages 1111-1120, XP002470185
• SHIMIZU, H. ET AL: "Warpage of Czchralski-Grown Silicon Wafers as Affected by Oxygen Precipitation" JAPANESE JOURNAL OF APPLIED PHYSICS, vol. 24, no. 7, July 1985 (1985-07), pages 815-821, XP002470186
• IKARI A ET AL: "DEFECT CONTROL IN NITROGEN DOPED CZOCHRALSKI SILICON CRYSTALS" DIFFUSION AND DEFECT DATA. SOLID STATE DATA. PART B, SOLID STATE PHENOMENA, VADUZ, LI, vol. 69/70, September 1999 (1999-09), pages 161-166, XP002928046 ISSN: 1012-0394
• "Octahedral void defects observed in the bulk of Czochralski silicon" APPLIED PHYSICS LETTERS, AIP, AMERICAN INSTITUTE OF PHYSICS, MELVILLE, NY, US, vol. 70, no. 10, 10 March 1997 (1997-03-10), pages 1248-1250, XP012017379 ISSN: 0003-6951
• STAVOLA M. ET AL: 'Diffusivity of oxygen in silicon at the donor formation temperature' APPLIED PHYSICS LETTERS vol. 42, no. 1, 01 January 1983, pages 73 - 75

**Description**

Technical Field

The present invention relates to a silicon wafer wherein both slip dislocation and warpage occurrence can be suppressed in a semiconductor wafer manufacturing technical field, especially, in a device manufacturing process, and a method for manufacturing the same.

Background Art

A silicon wafer used as a substrate for a semiconductor device or the like is manufactured by slicing a silicon single-crystal ingot and performing heat treatment, mirror-like finishing, or the like to the sliced ingot. As a method for manufacturing such a silicon single-crystal ingot, there is Czochralski method (hereinafter, called "C2 method"), for example. The CZ method occupies most part of manufacturing the silicon single-crystal ingot because it is easy to obtain a single-crystal ingot with a large diameter or defects can be controlled relatively easily.

A silicon single-crystal (hereinafter, called "CZ-Si") pulled up by the CZ method includes crystal defects called "grown-in defects". The CZ-Si takes interstitial oxygen in a supersaturated state, but such supersaturated oxygen causes induction of fine defects called Bulk Micro Defect (hereinafter, called "BMD") in a heat treatment (anneal) conducted thereafter.

In order to form a semiconductor device on a silicon wafer, it is required that no crystal defect is included in a semiconductor device forming region. This is because, when crystal defects are present on a face on which a circuit is formed, circuit breakage or the like is caused by the defect. On the other hand, it is required that the silicon wafer includes BMDs in a proper amount therein. This is because such BMDs serve to getter metal impurities or the like which causes semiconductor device malfunction.

In order to satisfy the abovementioned requirements, a method for performing high-temperature anneal to a silicon wafer to induce BMDs inside the silicon wafer to form an Intrinsic Gettering layer (hereinafter, "IG layer") and diminishing grown-in defects present in a surface of the silicon wafer to form a Denuded Zone layer (hereinafter, called "DZ layer) where crystal defects are infinitely reduced is used.

Specifically, a method for performing high-temperature anneal to a nitrogen-added substrate to reduce grown-in defects on a surface of the substrate and form BMDs including nitrogen as nuclei inside the substrate has been proposed (Patent Literature 1).

However, oxygen concentrations in DZ layers formed on both a front face and a back face of a silicon wafer in the abovementioned high-temperature anneal process have been lowered considerably due to outward diffusion of oxygen during heat treatment. As a result, since restraint of dislocation defect extension on the wafer front face and a back face lowers significantly, dislocation defect (hereinafter, called "slip") easily extends in a bulk from fine flaws on the front face and the back surface introduced in the anneal step, which results in such a problem that strength of the silicon wafer lowers due to extension of such slip dislocation. For example, when a silicon wafer is annealed under being supported by a heat treatment boat or the like, slip dislocations may often extend from near supported portion of a back face of the wafer supported by the heat treatment boat. Further, there is a case that slip dislocation extends from an edge portion of the silicon wafer.

When the strength of the silicon wafer lowers, there is a concern that such a situation that the wafer is damaged or broken during manufacturing step occurs. However, the DZ layer is essential for semiconductor device formation, and a silicon wafer having a DZ layer and excellent strength property has been required.

In the conventional method described in the following Patent Literature 1, strength lowering of a silicon wafer has not been considered so that extension of slip dislocation is unavoidable in a silicon wafer manufactured by such a method.

Meanwhile, a method for generating BMDs at a high density has been proposed in order to prevent occurrence of such slip dislocation.

Specifically, a silicon wafer manufacturing method where oxygen precipitation nuclei with sizes of 20nm or less in the amount of $1 \times 10^{10}$atoms/cm$^3$ or more are formed in the BMD layer by performing rapid temperature ramping up/down heat treatment to a substrate sliced from a silicon single-crystal ingot under atmosphere of nitrogen gas, inert gas, or mixed gas of ammonia gas and inert gas at a temperature of 500 to 1200°C in a range of 1 to 600 minutes has been proposed (Patent Literature 2). A silicon wafer where BMDs with a high concentration ($1 \times 10^{10}$atoms/cm$^3$ to $1 \times 10^{12}$atoms/cm$^3$) have been generated by repeating heat treatment step several times has been proposed (Patent Literature 3).

Patent Literature 1: JP-A-10-98047
Patent Literature 2: JP-A-2006-40980

Patent Literature 3: JP-A-08-213403

In Sueoka et al. "Effect of Oxide Precipitate Sizes on the Mechanical Strength of Czochralski Silicon Wafers", Japanese Journal of Applied Physics, vol. 36, issue Part 1, No. 12A, pp. 7095-7099, 12/1997, ISSN 0021-4922, the effect of oxide precipitate sizes on the mechanical strength of Czochralski silicon (CZ-Si) wafers has been studied with emphasis on the mechanism of slip dislocation generation by oxide precipitates. Thermal stresses, which are larger than those set up in wafers during actual device processes, were applied to two-step annealed wafers. It was determined by X-ray topography and transmission electron microscopy observations that both platelet and polyhedral precipitates can generate slip dislocations when their size is larger than approximately 200 nm. With further experiments, it is concluded that the precipitates cannot generate slip dislocations during actual device processing when the precipitate size is smaller than 200 nm, and this conclusion is independent of the precipitate density. The stress concentration of compressive thermal stresses applied to oxide precipitates should be the cause of slip dislocation generation. Three critical stress curves of slip dislocation generation were obtained for the wafers, in which the platelet sizes are approximately 70 nm, 200 nm and from 330 nm to 490 nm.

WO 2006/003812 A discloses a silicon wafer of large diameter that even when subjected to heat treatment, such as SLA or FLA, is free from any slip occurrence over a wide range of density of oxygen deposit, realizing a high strength. First, using as an input parameter each combination of multiple types of oxygen concentrations and heat histories set for the production of silicon wafer, the Fokker Planck equation is solved to thereby calculate both the diagonal length (L) and density (D) of oxygen deposit inside a wafer which is in the stage after heat treatment operation for formation of oxygen deposit but just before heat treatment operation of device manufacturing process.

Subsequently, maximum thermal stress (S) acting in the tangential direction of wafer circumference in the heat treatment operation of device manufacturing process is calculated on the basis of the structure of heat treatment furnace for use in the heat treatment operation of device manufacturing process and relevant heat treatment temperature. Thereafter, there is determined, for example, the oxygen concentration satisfying the relationship of the formula: 12000D = L = 51000S (1).

Disclosure of Invention

Problem to be solved by Invention

In recent years, however, since a silicon wafer is increased in diameter and the rapid temperature ramping up/down heat treatment by a Rapid Thermal Annealer (hereinafter, called "RTA") is frequently used, besides occurrence of slip dislocation, warpage generated in a wafer becomes problematic.

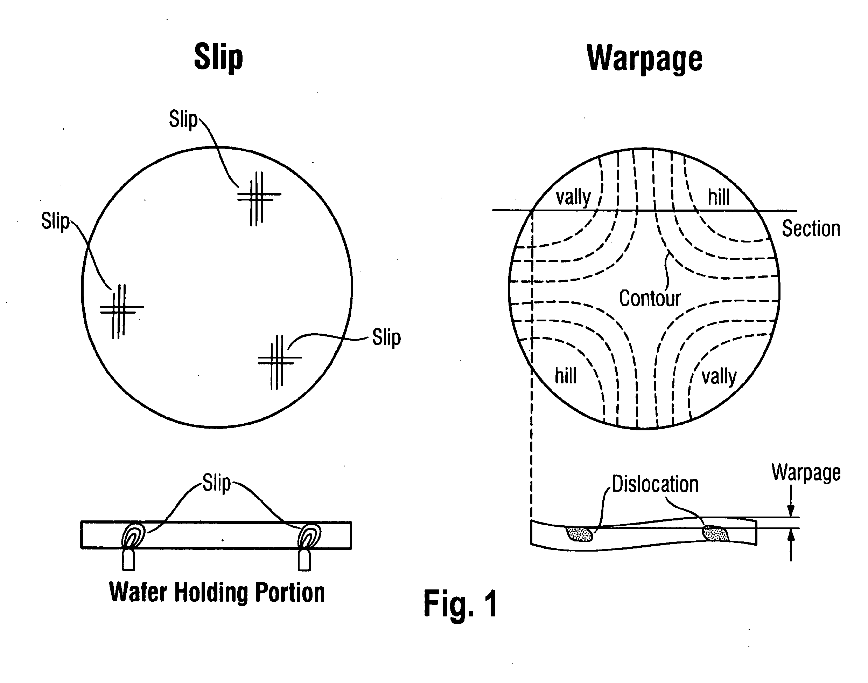

An illustration diagram of slips and warpage introduced by the RTA heat treatment is shown in FIG. 1. Slips are introduced from contacting points between a wafer back face and a wafer holding portions. The introduced slips extend in a 110 direction, which causes wafer damage or breakage in some cases. The warpage is a phenomenon where a wafer is deformed due to thermal strain during the RTA heat treatment. For example, hill-shaped portions and valley-shaped portions appear on a wafer of 100-plane, as shown in FIG. 1. Warpage of a silicon wafer before heat treatment for imparting desired properties to the wafer is conducted is suppressed to $10\mu$ m or less. However, when heat treatment such as the RTA is performed to the silicon wafer, such a case that a difference in height between a hill and a valley on a silicon wafer reaches several tens micron meters occurs. When the warpage becomes large, a semiconductor device pattern can not be exposed on a wafer surface accurately, which causes lowering of semiconductor device yield.

The problem of the warpage becomes significant when a wafer diameter reaches 200mm or more, and it is impossible to avoid the problem by only regulating the BMD concentration to a high concentration simply like the above.

Therefore, a problem to be solved by the present invention is to provide a silicon wafer that can suppress both occurrence of slip dislocation and occurrence of warpage in a device manufacturing process and a method for manufacturing the same.

Means for Solving the Problem

As a result of keen research for solving the abovementioned problems, the present inventors have clarified that BMDs included in a silicon wafer have a wide size distribution such as $10^5$ to $10^{13}/cm^3$ regarding the density or 5 to 1000nm regarding the size, and have obtained such a finding that occurrence of slip and warpage in a device manufacturing process can be significantly suppressed by controlling the density of BMDs with a predetermined size to complete the present invention.

That is, the present invention relates to a silicon wafer where BMDs with small sizes are formed in a high density and a density of BMDs with large sizes is reduced, preferably, interstitial oxygen concentration is further reduced, and a method for manufacturing the same. The present invention includes the following inventions (1) to (11).

(1) A silicon wafer where a shape of BMDs is octahedral wherein
a density of BMDs whose diagonal lengths are in a range of 10nm to 50nm, of BMDs present at a deep position which is inwardly spaced from a surface of a silicon wafer by a distance of 50$\mu$m or more, is $5 \times 10^{11}$/cm$^3$ or more,
a density of BMDs whose diagonal lengths are 300nm or more, of BMDs present at a deep position which is inwardly spaced from a surface of a silicon wafer by a distance of 50$\mu$m or more, is $1 \times 10^7$/cm$^3$ or less, and
an interstitial oxygen concentration is $5 \times 10^{17}$ atoms/cm$^3$ or less.
(2) A silicon wafer where plate-shaped BMDs and octahedral BMDs are present, wherein
a density of octahedral BMDs whose diagonal lengths are in a range of 10nm to 50nm, of BMDs present at a deep position which is inwardly spaced from a surface of a silicon wafer by a distance of 50$\mu$m or more, is $5 \times 10^{11}$/cm$^3$ or more,
a density of plate-shaped BMDs whose diagonal lengths are 750nm or more, of BMDs present at a deep position which is inwardly spaced from a surface of a silicon wafer by a distance of 50$\mu$m or more, are $1 \times 10^7$/cm$^3$ or less, and
an interstitial oxygen concentration is $5 \times 10^{17}$ atoms/cm$^3$ or less.
(3) A silicon wafer where a shape of BMDs is plate-shaped, wherein
a density of BMDs whose diagonal lengths are in a range of 10nm to 120nm, of BMDs present at a deep position which is spaced inwardly from a surface of a silicon wafer by a distance of 50$\mu$m or more, is $1 \times 10^{11}$/cm$^3$ or more,
a density of BMDs whose diagonal lengths are 750nm or more, of BMDs present at a deep position which is spaced inwardly from a surface of a silicon wafer by a distance of 50$\mu$m or more, is $1 \times 10^7$/cm$^3$ or less, and
an interstitial oxygen concentration is $5 \times 10^{17}$ atoms/cm$^3$ or less.
(4) The method for manufacturing the silicon wafer according to the above (1), wherein a heat treatment is preformed to a substrate including

(A): a low temperature heat treatment conducted at a temperature of 600 to 750°C for 30 minutes to 10 hours;
(B): a step including temperature ramping up to 1000°C at a temperature ramping up rate of 0.1 to 1°C/minute for 5 to 50 hours, and
(C): a high temperature heat treatment step conducted at a temperature of 1000°C to 1250°C for such time that a diffusion length of interstitial oxygen is in a range of 30$\mu$m to 50$\mu$m, where this diffusion length in$\mu$ m is given by $2 \times 10^4 \times$ (D $\times$ time [second])$^{0.5}$, with D [cm$^2$/second] = $0.17 \times$ exp (-2.53/(8.62 $\times$ 10$^5$ x Temperature [K]).

(5) A method for manufacturing the silicon wafer according to the above (1), wherein a heat treatment is performed to a substrate, the heat treatment including

(A): a step of performing a heat treatment at a temperature of 600 to 750°C for 30 minutes to 10 hours as a low temperature heat treatment step;
(B): a step including temperature ramping up to 800°C at a temperature ramping up rate of 0.1 to 1°C/minute for 1 to 20 hours as a temperature ramping up step after the low temperature heat treatment step;
(C): a step including ramping down the furnace temperature at a temperature ramping down rate of 1 to 10°C/minute, taking out a substrate outside furnace at the furnace temperature between 600°C to 800°C and cooling the substrate down to the room temperature ;and
(D): a step including taking a substrate inside the furnace at the furnace temperature between 600°C to 800°C and ramping up to 1000°C at a temperature ramping up rate of 1 to 10°C/minute and performing a heat treatment at a temperature of 1000°C to 1250°C for such time that a diffusion length of interstitial oxygen is in a range of 30 $\mu$m to 50 $\mu$m as a high temperature heat treatment step, where this diffusion length in $\mu$m is given by $2 \times 10^4 \times$ (D $\times$ time [second])$^{0.5}$, with D [cm$^2$/second] = $0.17 \times$ exp (-2.53/(8.62 $\times$ 10$^{-5}$ x Temperature [K]).

(6) A method for manufacturing the silicon wafer according to the above (2), wherein
a nitrogen concentration in a substrate is in a range of $5 \times 10^{14}$atoms/cm$^3$ to $1 \times 10^{16}$atoms/cm$^3$, and
a heat treatment is performed to the substrate, the heat treatment including:

(A): a low temperature heat treatment conducted at a temperature of 600 to 750°C for 30 minutes to 10 hours;
(B): a step including temperature ramping up conducted up to 1000°C at a temperature ramping up rate of 0.1 to 1°C/minute for 5 to 50 hours; and
(C): a high temperature heat treatment step performed at a temperature of 1000°C to 1250°C for such time that a diffusion length of interstitial oxygen is in a range of 30$\mu$m to 50$\mu$m, where this diffusion length in $\mu$m is given by $2 \times 10^4 \times$ (D $\times$ time [second])$^{0.5}$, with D [cm$^2$/second] = $0.17 \times$ exp (-2.53/(8.62 $\times$ 10$^5$ x Temperature [K]).

(7) A method for manufacturing the silicon wafer according to the above (2), wherein
a nitrogen concentration in a substrate is in a range of $5 \times 10^{14}$ atoms/cm$^3$ to $1 \times 10^{16}$ atoms/cm$^3$, and
a heat treatment is performed to the substrate, the heat treatment including:

(A): a step of performing a heat treatment at a temperature of 600°C to 750°C for 30 minutes to 10 hours as a low temperature heat treatment step;
(B): a step including temperature ramping up to 800°C at a temperature ramping up rate of 0.1 to 1°C/minute for 1 to 20 hours;
(C): a step including ramping down the furnace temperature at a temperature ramping down rate of 1 to 10°C/minute, taking out a substrate outside furnace at the furnace temperature between 600°C to 800°C and cooling the substrate down to the room temperature ;and
(D): a step including taking a substrate inside the furnace at the furnace temperature between 600°C to 800°C and ramping up to 1000°C at a temperature ramping up rate of 1 to 10°C/minute and performing a heat treatment at a temperature of 1000°C to 1250°C for such time that a diffusion length of interstitial oxygen is in a range of 30 μm to 50 μm as a high temperature heat treatment step,

where this diffusion length in μm is given by $2 \times 10^4 \times (D \times time \text{ (second)})^{0.5}$, with D [cm$^2$/second] = $0.17 \times \exp(-2.53/(8.62 \times 10^{-5} \text{ x Temperature [K]}))$.
(8) A method for manufacturing according to the above (3),
wherein
a heat treatment is performed to a substrate, the heat treatment including

(A): a low temperature heat treatment for performing a heat treatment at a temperature of 600°C to 750°C for 10 minutes to 10 hours;
(B): a temperature ramping up step including a step of performing temperature ramping up to 1000°C at a rate of 0.1°C/munite to 1C°/minute for 5 to 50 hours; and
(C): a high temperature heat treatment step conducted at a temperature of 1000°C to 1250°C for such time that a diffusion length of interstitial oxygen is in a range of 20μm to 30μm, where this diffusion length in μm is given by $2 \times 10^4 \times (D \times time \text{ [second]})^{0.5}$, with D [cm$^2$/second] = $0.17 \times \exp(-2.53/(8.62 \times 10^{-5} \text{ x Temperature [K]}))$.

(9) A method for manufacturing a silicon wafer according to the above (3), wherein
a heat treatment is performed to a substrate, the heat treatment including:

(A): a step of conducting heat treatment at a temperature of 600°C to 750°C for 10 minutes to 10 hours as a low temperature heat treatment step;
(B): a step including temperature ramping up to 800°C at a temperature ramping up rate of 0.1 to 1°C/minute for 1 to 20 hours as a temperature rising step after the low temperature heat treatment step;
(c): a step including ramping down the furnace temperature at a temperature ramping down rate of 1 to 10°C/minute, taking out a substrate outside furnace at the furnace temperature between 600°C to 800°C and cooling the substrate down to the room temperature ;and
(D): a step including taking a substrate inside the furnace at the furnace temperature between 600°C to 800°C and heating up to 1000°C at a temperature ramping up rate of 1 to 10°C/minute and performing a heat treatment at a temperature of 1000°C to 1250°C for such time that a diffusion length of interstitial oxygen is in a range of 20μm to 30μm as a high temperature heat treatment step,

where this diffusion length in μm is given by $2 \times 10^4 \times (D \times time \text{ [second]})^{0.5}$, with D [cm$^2$/second] = $0.17 \times \exp(-2.53/(8.62 \times 10^{-5} \text{ x Temperature [K]}))$.
(10) The method for manufacturing according to the above (8) or (9), wherein
a nitrogen concentration in the substrate is in a range of $5 \times 10^{14}$ atoms/cm$^3$ to $1 \times 10^{16}$ atoms/cm$^3$.
(11) The method for manufacturing a silicon wafer according to any one of the above (4) to (9), wherein
a carbon concentration in the substrate is in a range of $2 \times 10^{15}$ atoms/cm$^3$ to $3 \times 10^{16}$ atoms/cm$^3$.

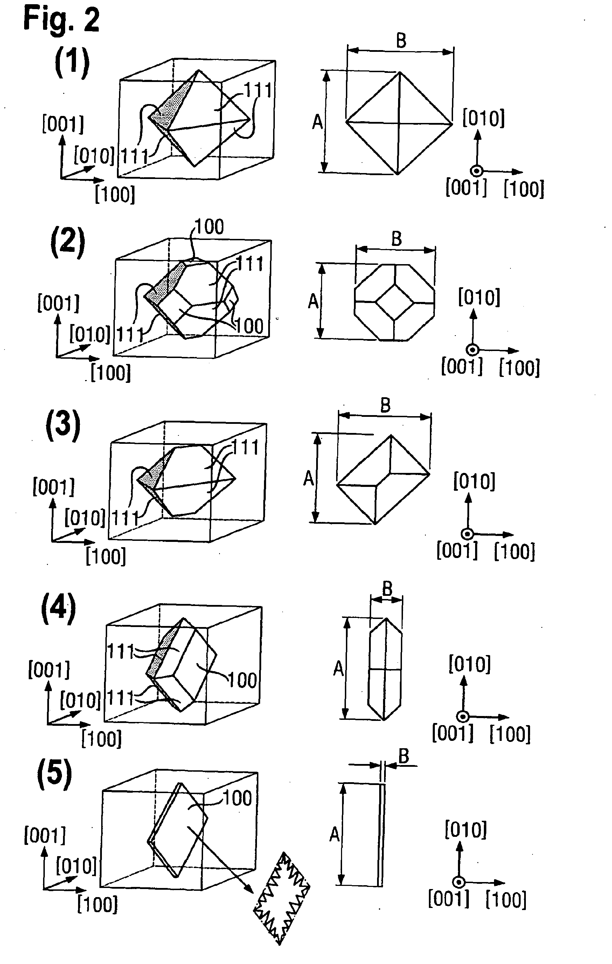

Here, in the present invention, the BMD having an octahedron shape means a BMD surrounded by a plurality of [111] planes and other planes, as shown in FIG. 2. There are generally an octahedron shape surrounded by eight faces of [111] plane, as shown in FIG. 2(1) or FIG. 2(3), and one surrounded by [100] plane together with [111] plane, as shown in FIG. 2(2). Another plane other than the [111] plane or [100] plane may appear on the BMD.
The shape of BMD present in a wafer may be plate-shaped in addition to the octahedron shape, and a plate-shaped BMD is a BMD surrounded by relatively large two face of [100] plane and other planes, as shown in FIG. 2(4) or FIG. 2(5). Inside of the BMD may be formed in a dendritic shape, as shown in FIG. 2(5). Regarding discrimination between the octahedron shape and the plate shape, as shown in FIG. 3, when a longer one of sizes of [100] direction and [010] direction viewed from [001] direction is represented as A and a shorter one thereof is represented as B, A/B (hereinafter, called "ellipticity") of 1.5 or less is defined as an octahedron shape, while A/B exceeding 1.5 is defined as a plate shape. Since there are variations in BMD shape in a silicon wafer, determination about whether the BMD present in a wafer is an octahedron shape or a plate shape can be made by measuring A/B of a plurality of BMDs present at different positions in a wafer to obtain an average value thereof (hereinafter, called "average ellipticity") and determining whether or not the average value exceeds 1.5. When the average value exceeds 1.5, strain applied to crystal lattice around a BMD is changed, so that an optimal BMD size distribution for suppressing occurrence of slips and warpage are changed.

Further, in the present invention, the diagonal length of the BMD means a longer one A of the abovementioned [100] direction and [010] direction.

Effect of the Invention

The silicon wafer according to the present invention where a density of BMDs with predetermined sizes is controlled in the abovementioned manner so that occurrence of both a slip and warpage is considerably suppressed in a device manufacturing process and which has a DZ layer while can prevent strength lowering has a large diameter (typically, 200mm or more) and makes it possible to manufacture a device with a high quality.

The silicon wafer according to the present invention is reduced in occurrence of slip dislocation and warpage as compared with a mirror wafer which does not have BMD therein and has high gettering ability.

The silicon wafer according to the present invention can reduce change of a BMD distribution at a heat treatment in a device manufacturing process and can prevent occurrence of slips and warpage due to the change because an interstitial oxygen concentration is $5 \times 10^{17}$ atoms/cm$^3$ or less.

According to the manufacturing method according to the present invention, a silicon wafer of the present invention having such excellent properties as described above can be manufactured.

Best Mode for Carrying out the Invention

The present invention will be explained in detail below along embodiments.

Silicon Wafer

A silicon wafer according to the present invention is **characterized in that** occurrence of both of slips and warpage in a device manufacturing process can be suppressed to a considerably small amount.

Here, a size (diameter and thickness) of a wafer where the present invention is realized and presence/absence of dope of various elements are not particularly limited. These features can be properly selected according to kinds of semiconductor silicon wafers required.

A semiconductor device manufactured using a silicon wafer of the present invention is not particularly limited and a silicon wafer of the present invention can be applied to manufacturing various semiconductor devices. Specifically, a silicon wafer of the present invention can be widely applied to manufacturing an epitaxial wafer formed with an epitaxial layer on a surface thereof, a laminated SOI wafer, an SIMOX wafer which has been subjected to SIMOX (Separation By Implanted Oxygen) process, or an SiGe wafer formed with an SiGe layer on a surface thereof, or the like.

A feature of a silicon wafer of the present invention lies in that, in a silicon wafer where a shape of BMDs is plate-shaped or octahedron, or plate-shaped BMDs and octahedral BMDs are present, a density of BMDs whose diagonal lengths are in a range of 10nm to 120nm, included in BMDs present at a deep position which is spaced inwardly from a surface of a silicon wafer by a distance 50μm or more, is $1 \times 10^{11}$/cm$^3$ or more in the case that the shape of BMDs is plate-shaped, and a density of BMDs whose diagonal lengths is in a range of 10nm to 50nm, of BMDs present at a deep position which is inwardly spaced from a surface of a silicon wafer by a distance of 50μm or more, is $5 \times 10^{11}$/cm$^3$ or more in the case that the shape of BMDs is octahedron. This is based upon the inventors' finding explained below.

That is, the BMDs present at a deep position which is spaced inwardly from a surface of a silicon wafer by a distance 50μm or more influence properties of slips or warpage, and in a silicon wafer where the BMDs having predetermined diagonal lengths are formed at a high density with a predetermined density or higher, occurrence of slips is considerably reduced in a general device manufacturing process, specifically slips generated are suppressed to 10mm or less. Thereby, even if a slip is generated at a wafer supporting portion in a device manufacturing process, the slip can be prevented from being exposed to a surface of the silicon wafer, and even if a slip is generated at a wafer edge portion, it can be prevented from reaching a semiconductor device manufacture region, so that adverse influence to a device can be prevented.

When diagonal lengths of octahedral BMDs are less than 10nm or a octahedral BMD density is less than $5\times10^{11}$/cm$^3$, or when diagonal lengths of plate-like BMDs are less than 10nm or a octahedral BMD density is less than $1\times10^{11}$/cm$^3$, BMDs do not serve as a sufficient barrier with respect to slip propagation. There is no upper limits to the diagonal length of BMDs which may serve as a barrier to slip propagation, but upper limits of ranges of the BMD diagonal length realized in an actual silicon wafer are 50nm in the case of octahedral BMD, and 120nm in the case of plate-like BMD, as described as follows. When the BMDs are present at a high density, virtually all solid solution oxygen has precipitated as BMDs. Meanwhile, the number of oxygen atoms precipitating as BMDs does not exceed the number of oxygen atoms dissolved in CZ-Si as a solid solution, and thus the upper limit of the solid solution oxygen concentration is about $1\times1018$ atoms/cm$^3$ at most. When BMDs are present at a high density like $1\times10^{11}$/cm$^3$ or more, it can be seen that the oxygen atoms precipitating as BMDs reaches to upper limit and that it is almost constant (about $1\times1018$ atoms/cm$^3$ in density). In this state, as diagonal length of BMDs increases, a density of BMDs becomes small. Accordingly, it is impossible to realize octahedral BMDs present at a density of $5\times10^{11}$/cm$^3$ such that their diagonal lengths are more than 50nm, and it is impossible to realize plate-like BMDs present at a density of $1\times10^{11}$/cm$^3$ such that their diagonal lengths are more than 120nm.

Since the plate-shaped BMD has a barrier effect to slip propagation stronger than that of the octahedral BMD, it is expected that it can exert slip suppression effect even at a density lower than octahedron.

When BMDs formed in a high density are plate-shaped, it is preferable that the density of the BMDs having diagonal lengths in such a range is $1 \times 10^{12}$/cm$^3$ or more, or the diagonal lengths of all the BMDs are 30nm or more and the density of BMDs whose diagonal lengths are 120nm or less is $1 \times 10^{11}$/cm$^3$. When BMDs formed in a high density are octahedral, it is preferable that the density of the BMDs having diagonal lengths in such a range is $1 \times 10^{12}$/cm$^3$ or more, or the diagonal lengths of all the BMDs are 20nm or more and the density of BMDs whose diagonal lengths are 50nm or less is $5 \times 10^{11}$/cm$^3$. Thereby, the length of a slip generated in a general device manufacturing process can be suppressed to be further small (typically, 5mm or less). In a device in a current generation, when the length of a slip is suppressed to 10mm or less, no problem occurs. But since a silicon wafer is used up to a region of its edge as a device region in the next generation device applied with such a design rule of 50nm or less, it is desirable that the length of the slip is suppressed to 5mm or less.

In addition to the abovementioned characteristic feature, another characteristic feature of the silicon wafer of the present invention lies in that a density of plate-shaped BMDs whose diagonal lengths are 750nm or more, included in BMDs present at a deep position which is spaced inwardly from a surface of a silicon wafer by a distance exceeding 50$\mu$m, is $1 \times 10^7$/cm$^3$ or less. This is based upon the inventors' finding described below.

That is, when thermal stress acts on a wafer, high-density dislocation is easily generated inside the wafer from BMDs with a predetermined size or more of BMDs present at a deep position which is spaced inwardly from a surface of a silicon wafer by a distance of 50$\mu$m or more as a starting point, so that the wafer is plastically deformed and warpage is caused. By reducing such BMDs to a predetermined density ($1 \times 10^7$/cm$^3$) or less, occurrence of warpage in a general device manufacturing process can be suppressed remarkably, typically, to 20$\mu$m or less. The plate-shaped BMDs are harder to generate dislocation inside a wafer causing warpage than the octahedral BMDs. Therefore, it is preferable that such BMDs with a predetermined size or more are plate-shape.

In addition to the abovementioned characteristic features, another characteristic feature of the silicon wafer of the present invention lies in that the octahedral BMDs whose diagonal lengths are 300nm or more, included in BMDs present at a deep position which is spaced inwardly from a surface of a silicon wafer by a distance exceeding 50$\mu$m, is $1 \times 10^7$/cm$^3$ or less. This is based upon the inventors' finding described below.

That is, when thermal stress acts on a wafer, high-density dislocation is easily generated inside the wafer from BMDs with large sizes of BMDs present at a deep position which is spaced inwardly from a surface of a silicon wafer by a distance of 50$\mu$m or more as a starting point, so that the wafer is plastically deformed and warpage is caused. Especially, BMDs whose diagonal lengths are 300nm or more of the BMDs with large sizes easily serve as a generation source of dislocation, so that occurrence of warpage in a general device manufacturing process can be suppressed remarkably, typically, to 20$\mu$m or less by suppressing such BMDs to $1 \times 10^7$/cm$^3$ or less.

In the silicon wafer of the present invention, it is further preferable that an average value of interstitial oxygen concentrations is reduced in addition to the characteristic feature explained above.

Here, the interstitial oxygen concentration is generally measured regarding the whole silicon wafer, and not only the BMD layer but also the DZ layer is included in a measurement region. However, since the DZ layer is considerably thinner than the BMD layer, it can be thought that the interstitial oxygen concentration measured over the whole silicon wafer is the same as the interstitial oxygen concentration in the BMD layer.

The reason why the interstitial oxygen concentration is specified over the whole silicon wafer in this manner is based upon the inventors' unexpected finding that the optimal BMD distribution (size and density) explained above changes due to precipitation of interstitial oxygen depending on conditions of heat treatment in a device manufacturing process and slips or warpage may occur due to the change.

It is preferable that the interstitial oxygen concentration is $5 \times 10^{17}$ atoms/cm$^3$ or less in order to achieve the above object. On the other hand, the lower limit of the interstitial oxygen concentration is around $2 \times 10^{17}$ atoms/cm$^3$. This is because heat treatment at a low temperature for a considerably long time is difficult to realize, because it is required in order to further reduce the interstitial oxygen concentration beyond the lower limit.

It is preferable that the BMD size distribution and the interstitial oxygen concentration explained above are realized over the whole wafer surface, but they may be realized on a partial region of the whole wafer surface depending on application of the wafer. For example, in order to prevent only a typical slip introduced from an edge portion of a wafer, it is only required that the abovementioned BMD size distribution and interstitial oxygen concentration are realized on a region spaced from the center of a wafer by 80% or more of a wafer radius. This is because the slip introduced from an edge portion of a wafer mainly occurs on a region spaced from the center of a wafer by 80% or more in many cases. In order to prevent only typical warpage of a wafer, it is only required that the abovementioned BMD size distribution and interstitial oxygen concentration are realized on a region positioned inside by less than 80% of a wafer radius. This is because typical high-density dislocation inside the wafer causing warpage occurs in a region positioned inside by 80% or less of the wafer radius.

The silicon wafer of the present invention is remarkably excellent regarding such a fact that slips and warpage generated in a device manufacturing process are small. More specifically, the silicon wafer according to the present invention, especially, a silicon wafer where BMDs have been controlled in the above manner and whose interstitial oxygen concentration has been reduced, is **characterized in that** a length of a slip generated even in the following heat treatment is considerably short (typically, a length of a slip is 10mm or less, and an amount of warpage of a wafer after heat treatment is 20μm or less).

That is, as heat treatment for evaluating resistance to occurrence of slips or warpage in a device manufacturing process, there is heat treatment where a temperature in a temperature region of 700°C to 1100°C is ramped up/down at a temperature ramping up rate of 30°C/second or more and the raised temperature is held at a temperature of 1100°C or higher.

Such heat treatment is done in the temperature region where slips or warpages is easy to occur and thermal stress becomes practically maximum, it can be said that a silicon wafer where occurrence of slips and warpage in all a general device manufacturing process is considerably reduced is obtained by preventing occurrence of dislocation in the temperature range at the temperature ramping up/down rate.

For measurement of the shape of BMD, the diagonal length and the number of BMDs explained above can be performed by an ordinary known measuring method. More specifically, such measurement includes measurement utilizing a transmission electron microscope (hereinafter, called "TEM") and an Optical Precipitate Profiler (hereinafter, called "OPP").

There is no limitation regarding measurement of a slip dislocation of a wafer, measurement of a warpage amount, and an evaluation method, and they can be measured by utilizing ordinary known methods. More specifically, an X-ray topograph can be utilized for measurement of the slip dislocation, and an amount of warpage can be evaluated by performing observation utilizing FT-90A manufactured by NIDEK Corporation or the like.

Further, Furrier transform infrared absorption spectroscopy (FTIR) can be used for measuring an interstitial oxygen concentration.

Method for Manufacturing Silicon Wafer

The silicon wafer according to the present invention has the feature explained above. Accordingly, any method for manufacturing a silicon wafer having such a feature can be adopted without limitation. Specifically, the silicon wafer having the abovementioned feature can be manufactured by controlling single-crystal growth conditions (a crystal pulling-up rate, a crystal cooling rate, a crucible rotation, gas flow, and the like) or heat treatment conditions (a heat treatment temperature, a time, a temperature rising/falling, and the like) properly.

In the present invention, especially, it is preferable to perform heat treatment to a substrate in a stepwise manner.

Here, the term "substrate" means a silicon wafer before being subjected to heat treatment, and the substrate includes one which has been sliced from a single-crystal ingot and has been subjected to such a step as chamfering step properly except for the heat treatment.

There is neither specific limitation about size (diameter, thickness, and the like) nor specific limitation about presence/absence of dope of various elements, and these factors can be selected according to required kind and performance of a silicon wafer.

In the present invention, when a silicon wafer where a shape of BMDs is octahedral-shaped is manufactured, the abovementioned heat treatment includes (A): a low temperature heat treatment conducted at a temperature of 600 to 750°C for 30 minutes to 10 hours; (B): a temperature rising step including a step of temperature rising up to 1000°C conducted at a temperature rising rate of 0.1°C/minute to 1°C/minute for 5 to 50hours, and (C): a high temperature heat treatment step conducted at a temperature of 1000°C to 1250°C such that a diffusion length of interstitial oxygen is in a range of 30μm to 50μm. When a silicon wafer where a shape of BMDs is plate-shaped is manufactured, more preferably, the abovementioned heat treatment includes (A): a low temperature heat treatment conducted at a temperature of 600 to 750°C for 10 minutes to 10 hours; (B): a temperature ramping up step including a step of temperature ramping up to 1000°C conducted at a temperature ramping up rate of 0.1°C/minute to 1°C/minute, and (C): a high temperature heat treatment step conducted at a temperature of 1000°C to 1250°C such that a diffusion length of interstitial oxygen is in a range of 20$\mu$m to 30$\mu$m. When a silicon wafer where plate-shaped BMDs and octahedral BMDs are included in a mixed manner is manufactured, the abovementioned heat treatment includes (A): a low temperature heat treatment conducted at a temperature of 600 to 750°C for 30 minutes to 10 hours; (B): a temperature rising step including a step of temperature ramping up to 1000°C conducted at a temperature ramping up rate of 0.1°C/minute to 1°C/minute, and (C): a high temperature heat treatment step conducted at a temperature of 1000°C to 1250°C such that a diffusion length of interstitial oxygen is in a range of 30$\mu$m to 50$\mu$m.

At the step (A), when a temperature in the heat treatment is less than 600°C, since diffusion of oxygen does not take place sufficiently, BMD formation can not be achieved sufficiently, which is not preferable. On the other hand, even if the temperature exceeds 750°C, BMD optimization is hardly influenced, which results in undesirable wastefulness. When a time period for the heat treatment is short, a time for BMD nuclei formation is insufficient, and the BMD density does not reach a predetermined density or more, which is not preferable (when the heat treatment time is less than 10 minutes, the BMD density becomes less than $1 \times 10^{11}$/cm$^3$, and when the time is less than 30 minutes, the BMD density becomes less than $5 \times 10^{11}$/cm$^3$). Further, when the heat treatment time exceeds 10 hours, productivity lowers, which is not preferable.

The step (B) is performed for changing the density of BMDs whose diagonal lengths are 5nm or more to a predetermined density (when the BMDs are plate-shaped, the density is $1 \times 10^{11}$/cm$^3$, and when the BMDs are octahedral, the density is $5 \times 10^{11}$/cm$^3$) and changing the interstitial oxygen concentration to $5 \times 10^{17}$atoms/cm$^3$ or less in the stage where the temperature has ramped up to 1000°C. When the diagonal length is less than 5nm, the BMDs diminish and disappear at the following high temperature heat treatment (C), so that the BMD density in the silicon wafer after being subjected to the following high temperature heat treatment may become less than the predetermined density, which is not preferable. When the density of BMDs whose diagonal lengths are 5nm or more is less than the predetermined density, the BMD density in the silicon wafer after the following high temperature heat treatment has been conducted may become less than the predetermined density, which is not preferable. When the interstitial oxygen concentration exceeds $5 \times 10^{17}$atoms/cm$^3$, the interstitial oxygen concentration exceeds $5 \times 10^{17}$atoms/cm$^3$ even in the silicon wafer after being subjected to the following high temperature heat treatment or the BMD density where the shape of the BMDs is plate-shaped and the diagonal lengths of the BMDs are 750nm or more exceeds $1 \times 10^7$/cm$^3$, which is not preferable. This will be because interstitial oxygen in the silicon wafer builds up at BMDs while the interstitial oxygen is externally diffused at the high temperature heat treatment (C). At this step (B), when the temperature ramping up rate is less than 0.1°C/minute, a stable temperature rising rate can not be secured in view of a relationship of control on a heat treatment furnace, which is not preferable. When the temperature ramping up rate exceeds 1°C/minute, BMDs produced at the step (A) disappear during temperature rising, so that the BMD density becomes less than $5 \times 10^{11}$/cm$^3$ at the stage where the temperature has risen up to 1000°C, which is not preferable. When the step of conducting temperature ramping up at the temperature ramping up rate of 0.1°C/minute to 1°C/minute is conducted for less than 5 hours, BMDs produced at the step (A) disappear during temperature ramping up, so that the BMD density becomes less than the predetermined density (when the BMDs are plate-shaped, the density is $1 \times 10^{11}$/cm$^3$, and when the BMDs are octahedral, the density is $5 \times 10^{11}$/cm$^3$) at the state that the temperature has ramped up to 1000°C, which is not preferable. When the temperature ramping up step exceeds 50 hours, productivity extremely lowers, which is not preferable. When the diffusion length of the interstitial oxygen is less than 5$\mu$m, the interstitial oxygen concentration in the stage that the temperature has ramped up to 1000°C exceeds $5 \times 10^{17}$ atoms/cm$^3$, which is not preferable.

Measurement of the BMD density and the interstitial oxygen concentration in the stage that the temperature has ramped up to 1000°C can be conducted after a silicon wafer is rapidly pulled out from a furnace in the stage that the heat treatment (B) has been completed and the wafer is ramped down to the room temperature. A ramping down rate at this time may be a ramping down rate within a range which can be realized in an ordinary butch-type vertical furnace.

Further, the step (C) is for diffusing interstitial oxygen outwardly and forming a DZ layer. At this step, when the temperature is less than 1000°C, a long time is required for outward diffusion of the interstitial oxygen, which is not preferable in view of productivity. When the temperature exceeds 1250°C, degradation of the anneal furnace is accelerated, which is not preferable. The diffusion length of the interstitial oxygen is a numerical value calculated based upon the temperature and the time at this step, and it can be specifically obtained according to the following equation (i).

$$\text{Diffusion length of interstitial oxygen } (\mu m) = 2 \times 10^4 \times (D \times \text{time (second)})^{0.5} \qquad (i)$$

where,

$$D\ (cm^2/second)\ =\ 0.17\ \times\ exp\ (-2.53 \div 8.62\ \times\ 10^{-5} \div temperature\ (K))$$

Diffusivity D with exponent 2.53 can be found by regression analysis. Such types of equations and ways to determine the diffusivity D are described in Stavola et al., "Diffusivity of oxygen in silicon at the donor formation temperature", Appl. Phys. Lett. 42 (1), 1983.

Thus, the heat treatment where the diffusion length of interstitial oxygen becomes $20\mu m$ or more is preferable for forming a wide DZ layer such as a wide of $5\mu m$ or more.

When the diffusion length of interstitial oxygen is less than $30\mu m$, the BMD shape after the high temperature heat treatment (C) has been completed becomes plate-shaped, while the BMD shape becomes octahedral when the diffusion length of interstitial oxygen is equal to or more than $30\mu m$. Incidentally, even when the diffusion length of interstitial oxygen is equal to or more than $30\mu m$, the shape of BMDs with relatively large sizes may be formed in a plate shape, for example, by adding nitrogen, as described later. Such a high temperature heat treatment that the diffusion length of interstitial oxygen exceeds $40\mu m$ requires excessive time, resulting in lowering productivity, which is not preferable.

There particularly is no limitation regarding the temperature ramping up from the step (B) to the step (C), where an ordinary temperature ramping up rate can be used preferably. The most general temperature ramping up rate is in a range of 1°C/minute to 10°C/munite or so.

In the present invention, when a silicon wafer where a shape of BMDs is octahedral-shaped is manufactured, the abovementioned heat treatment includes (A): a low temperature heat treatment conducted at a temperature of 600 to 750°C for 30 minutes to 10 hours; (B): a temperature ramping up step including a step of temperature ramping up to 800°C conducted at a temperature ramping up rate of 0.1°C/minute to 1°C/minute for 1 to 10hours, and (C): a step including ramping down the furnace temperature at a temperature ramping down rate of 1 to 10°C/minute, taking out a substrate outside furnace at the furnace temperature between 600°C to 800°C and cooling the substrate down to the room temperature ;and(D) a step including taking a substrate inside the furnace at the furnace temperature between 600°C to 800°C and ramping up to 1000°C at a temperature ramping up rate of 1°C/minute to 10°C/minute and performing a heat treatment at a temperature of 1000°C to 1250°C such that a diffusion length of interstitial oxygen is in a range of $30\mu m$ to $50\mu m$ as a high temperature heat treatment step. when a silicon wafer where a shape of BMDs is plate-shaped is manufactured, the abovementioned heat treatment includes (A): a low temperature heat treatment conducted at a temperature of 600 to 750°C for 30 minutes to 10 hours; (B); a temperature ramping up step including a step of temperature ramping up to 800°C conducted at a temperature ramping up rate of 0.1°C/minute to 1°C/minute for 1 to 10hours, and (C): a step including ramping down the furnace temperature at a temperature ramping down rate of 1 to 10°C/minute, taking out a substrate outside furnace at the furnace temperature between 600°C to 800°C and cooling the substrate down to the room temperature ;and (D) a step including taking a substrate inside the furnace at the furnace temperature between 600°C to 800°C and ramping up to 1000°C at a temperature ramping up rate of 1°C/minute to 10°C/minute and performing a heat treatment at a temperature of 1000°C to 1250°C such that a diffusion length of interstitial oxygen is in a range of $30\mu m$ to $50\mu m$ as a high temperature heat treatment step. When a silicon wafer where plate-shaped BMDs and octahedral BMDs are included in a mixed manner is manufactured, (A): a low temperature heat treatment conducted at a temperature of 600 to 750°C for 30 minutes to 10 hours; (B); a temperature ramping up step including a step of temperature ramping up to 800°C conducted at a temperature ramping up rate of 0.1°C/minute to 1°C/minute for 1 to 10hours, and (C): a step including ramping down the furnace temperature at a temperature ramping down rate of 1 to 10°C/minute, taking out a substrate outside furnace at the furnace temperature between 600°C to 800°C and cooling the substrate down to the room temperature ;and(D) a step including taking a substrate inside the furnace at the furnace temperature between 600°C to 800°C and ramping up to 1000°C at a temperature ramping up rate of 1°C/minute to 10°C/minute and performing a heat treatment at a temperature of 1000°C to 1250°C such that a diffusion length of interstitial oxygen is in a range of $20\mu m$ to $30\mu m$ as a high temperature heat treatment step.

The reason to add the (C) a taking out step is that if there are two furnaces the heat treatment (A),(B) and the heat treatment (D) might be separately performed to increase productivity. In this case at the step(B) temperature ramping up to 800°C at a temperature ramping up rate of 0.1°C/minute to 1°C/minute is sufficient to get more predetermined BMD density ( plate-shaped: $1 \times 10^{11}/cm^3$, octahedral; $5 \times 10^{11}/cm^3$ ). When the heat treatment process is divided, it is not necessary to ramp up more than 800°C. It is thought that during the step(C) BMDs which is formed after the step (C) have changed not to shrink or disappear at the step (D). So it is not necessary to ramp up to 1000°C at the ramping up rate of 0.1°C/minute to 1°C/minute like continuously processed one.

At this step (B), when the temperature ramping up rate is less than 0.1°C/minute, a stable temperature ramping up can not be secured in view of a relationship of control on a heat treatment furnace, which is not preferable. When the temperature ramping up rate exceeds 1°C/minute, BMDs produced at the step (A) disappear during temperature ramping up. When a time period is less than 1 hour BMDs produced at the step (A) disappear during temperature ramping up, which is not preferable. When the temperature ramping up step exceeds 10 hours, productivity lowers, which is not preferable. At this step, when the temperature is less than 800°C, BMDs might disappear.

At the step (C) it is preferable to ramp down at the temperature ramping rate in a range of 1°C/minute to 10°C/minute which is used in a conventional furnace,

it is not preferable to take out a substrate from the furnace at the furnace temperature less than 600°C because of shortening the life of heater.

It is not preferable to take out a substrate from the furnace at the furnace temperature more than 800°C because of deteriorating the material of furnace.

At the step (D), it is the same reason as the step (C),

it is not preferable to take a substrate inside the furnace at the furnace temperature of less than 600°C or more than 800 °C. The temperature ramping up rate to 1000°C is in a range of 1°C/minute to 10°C/minute which is used in a conventional furnace.

There is no limitation regarding the temperature ramping down rate.

There is particularly no limitation regarding an apparatus used in a series of heat treatments explained above, and a conventionally known apparatus is used preferably. Specifically, such an apparatus may be an ordinary batch-type vertical furnace, a batch-type vertical furnace with an oxygen purging function, and the like.

In the manufacturing method of the present invention, it is preferable that the substrate contains nitrogen. This is because warpage is further suppressed to a small amount (typically, 15μm or less) owing to such a fact that the substrate contains nitrogen. Thus, manufacturing a device with higher performance can be made possible by further suppressing warpage.

It is preferable that a concentration of nitrogen, added for this object is in a range of $5 \times 10^{14}$atoms/cm$^3$ to $1 \times 10^{16}$atoms/cm$^3$. When the concentration exceeds such a range, poly-crystallization takes place so that yield may lower, which is not preferable.

Further, when nitrogen is added within such a concentration range, a shape of BMDs with relatively large sizes can be formed in a plate shape even in such a relatively high temperature heat treatment that the diffusion length of interstitial oxygen becomes 30μm or more in a temperature range of, for example, 1100°C or more, so that a possibility of occurrence of dislocation causing warpage is reduced. Incidentally, in this case, a shape of BMDs whose sizes are relatively small and which are present in a high density is octahedron. It is thought that an effect imparted to the BMD shape by nitrogen is hard to act on such high-density BMDs.

For example, when a silicon wafer having a DZ layer with a thickness of 7μm or more is manufactured, it is necessary to conduct such a heat treatment that the diffusion length of interstitial oxygen becomes 30μm or more in a temperature range of 1100°C or more. In such a case, it is effective for reducing warpage that the shape of BMDs with a predetermined size or more is made plate-shaped by adding nitrogen.

In the manufacturing method of the present invention, it is preferable that the substrate contains carbon. This is because such an effect that BMDs with a relatively high density can be formed even if the low temperature heat treatment performed at step (A) is performed at a relatively low temperature for a short time can be obtained owing to such a fact that the substrate contains carbon.

It is preferable that a concentration of carbon added for this object is in a range of $2 \times 10^{15}$atoms/cm$^3$ to $3 \times 10^{16}$atoms/cm$^3$. When carbon is added in an amount exceeding such a range, the interstitial oxygen after the heat treatment increases, which is not preferable. The reason is not clear, but interstitial oxygen may be blocked to come together to BMDs by carbon.

Incidentally, there is particularly no limitation regarding a method for adding nitrogen or carton to a substrate, and a conventionally known method can be used preferably. More specifically, in a method for adding nitrogen, a substrate with a nitrogen film is added to melt for pulling up a single crystal so that a nitrogen concentration in the substrate to be obtained can be adjusted. In a method for adding carbon, carbon powder is added to melt for pulling up a single crystal so that a carbon concentration in the substrate to be obtained can be adjusted.

There is particularly no limitation about measuring methods of concentrations of nitrogen, carbon, and oxygen contained in a substrate, and they can be preferably measured by conventionally known methods. More specifically, the nitride concentration can be measured by using a secondary ion mass spectrometer (SIMS). Regarding measurements of the oxygen and carbon concentrations, measurements are conducted by an infrared absorption spectrophotometry and the concentrations can be obtained from values of JEITA (Japan Electronics and Information Technology Industries Association) used as conversion factors.

Examples

The present invention is explained in detail below with Examples, but it is not limited to the Examples.

Method for Manufacturing Annealed Wafer and Epitaxial Wafer

Single-crystal ingots were manufactured under various conditions (wafer diameter, conduction type, oxygen concentration, nitrogen concentration, and carbon concentration), the same sites of straight barrel portions of respective signal-crystal ingots were cut out by using a wire saw, and substrates with thickness sizes of 725 to 750$\mu$m obtained by applying mirror finishing to the cut-out ingots were defined as substrates. The substrates thus obtained were put in a batch-type vertical heat treatment furnace, and first heat treatments (A.and B) and a second heat treatment (C) were performed to the substrates inside the same furnace under argon atmosphere. The conditions of respective heat treatments are as shown in 1) to 6). Annealed wafers and epitaxial wafers were manufactured in this manner. Incidentally, in the Examples, a wafer which has been subjected to heat treatment and satisfies the following conditions 1) to 6) is defined as "annealed wafer" and a wafer on which an epitaxial layer has been deposited and which satisfies the conditions 2) and 4) is defined as "epitaxial wafer". The diffusion length of interstitial oxygen in each heat treatment was obtained by integrating the abovementioned equation (i) regarding a temperature and a time according to a temperature pattern of the second heat treatment. The heat treatment conditions for each Example and Comparative Example are as follows. The epitaxial layer deposition was conducted by depositing an epitaxial layer on a surface of an annealed wafer up to a thickness of 5$\mu$m in a vapor growth apparatus.

1) Table 1

First Heat treatment: after heat treatment at a temperature of 700°C for 1 hour, temperature rising from 700°C to 1000°C at a temperature ramping up rate of 1°C/minute.
Second heat treatment: temperature rising from 1000°C to 1100°C at a temperature rising rate of 5°C/minute and holding a wafer at a temperature of 1100°C for 4 hours.

Temperature cooling step: temperature cooling from 1100°C to 700°C at a temperature cooling rate of 1°C/minute to 5°C/minute.
2) Table 2
epitaxial layer deposition after the heat treatment shown in Table 1.
3) Table 3

First Heat Treatment: after heat treatment at a temperature of 700°C for 4 hours, temperature rising from 700°C to 1000°C at a temperature rising rate of 1°C/minute.
Second Heat Treatment: temperature rising from 1000°C to 1100°C at a temperature rising rate of 5°C/minute, temperature rising from 1100°C to 1200°C at a temperature rising rate of 1°C/minute, and holding a substrate at a temperature 1200°C for 1 hour.

Temperature cooling step: temperature cooling from 1100°C to 700°C at a temperature cooling rate of 1°C/minute to 5°C/minute.
4) Table 4
epitaxial layer deposition after heat treatment shown in Table 3.
5) Table 5
the same as heat treatment shown in Table 3.
6) Table 6
epitaxial layer deposition after heat treatment shown in Table 5.
7) Table 7

First Heat Treatment: after heat treatment at a temperature of 700°C for 1 hour, temperature ramping up from 700°C to 800°C at a temperature ramping up rate of 1°C/minute, temperature ramping down from 800 to 700°C at a temperature ramping down rate of 2°C/minute, taking out a wafer from a furnace at a temperature of 700°C, and cooling the wafer down to the room temperature.
Second Heat Treatment: insertion of wafer at a temperature of 700°C, temperature ramping up from 700°C to 1100°C at a temperature ramping up rate of 5°C/minute, and holding the wafer at a temperature of 1100°C for 4 hours.

Temperature ramping down step: temperature ramping down from 1100°C to 700°C at a temperature ramping down rate of 1°C/minute to 5°C/minute.

8) Table 8

First heat treatment: after heat treatment at a temperature of 700°C for 4 hours, temperature ramping up from 700°C to 800°C at a temperature ramping up rate of 0.5°C/minute, temperature ramping down from 800 to 700°C at a temperature ramping down rate of 2°C/minute, taking out a substrate from a furnace at a temperature of 700°C, and cooling the wafer down to the room temperature.

Second heat treatment: insertion of a substrate at a temperature of 700°C, temperature ramping up from 700°C to 1100°C at a temperature ramping up rate of 5°C/minute, temperature ramping up/ramping down between 1000°C and 1200°C at a temperature ramping up/ramping down rate of 1°C/minute, and holding a substrate at a temperature of 1200°C for 1 hour.

Temperature ramping down step: temperature ramping down from 1200°C to 700°C at a temperature ramping down rate of 1°C/minute to 5°C/minute.

9) Table 9

First heat treatment: after heat treatment at a temperature of 700°C for 4 hours, temperature ramping up from 700°C to 800°C at a temperature ramping up rate of 0.5°C/minute, temperature ramping down from 800 to 700°C at a temperature ramping down rate of 2°C/minute, taking out a substrate from a furnace at a temperature of 700°C, and cooling the substrate down to the room temperature.

Second heat treatment: insertion of a substrate at a temperature of 700°C, temperature ramping up from 700°C to 1100°C at a rate of 5°C/minute, temperature ramping up from 1000°C to 1200°C at a rate of 1°C/minute, and holding the wafer at a temperature of 1200°C for 1 hour.

Temperature ramping down step: temperature ramping down from 1200°C to 700°C at a temperature ramping down rate of 1°C/minute to 5°C/minute.

10) Table 10

Comparative Example 1

First heat treatment: after heat treatment at a temperature of 800°C for 4 hours, temperature ramping up from 800°C to 1000°C at a temperature ramping up rate of 1°C/minute.

Second heat treatment and temperature ramping down step: the same as second heat treatment and temperature ramping down step shown in Example in Table 1.

Comparative Example 2

First heat treatment: after heat treatment at a temperature of 700°C for 1 hour, temperature ramping up from 700°C to 1000°C at a temperature ramping up rate of 3°C/minute.

Second heat treatment and temperature ramping down step: the same as second heat treatment and temperature ramping down step shown in Example in Table 1.

Comparative Example 3

First heat treatment: after heat treatment at a temperature of 700°C for 30 minutes, temperature ramping up from 700°C to 1000°C at a temperature ramping up rate of 3°C/minute.

Second heat treatment: temperature ramping up from 1000°C to 1100°C at a temperature ramping up rate of 5°C/minute and holding a wafer at a temperature of 1100°C for 1 hour.

Temperature ramping down step: temperature ramping down from 1100°C to 700°C at a temperature ramping down rate of 1°C/minute to 5°C/minute. temperature ramping down step: the same as temperature ramping down step shown in Example in Table 1.

11) Table 11
Comparative Example 4

First heat treatment: after heat treatment at a temperature of 700°C for 4 hours, temperature ramping up from 700°C to 1000°C at a temperature ramping up rate of 3°C/minute.
Second heat treatment and temperature ramping daown step: the same as second heat treatment and temperature ramping down step in Example shown in Table 3.

12) Table 12
Comparative Example 5

First heat treatment: after heat treatment at a temperature of 800°C for 4 hours, temperature ramping up from 800°C to 1000°C at a temperature ramping up rate of 1°C/minute.
Second heat treatment and temperature ramping down step: the same as second heat treatment and temperature ramping down step in Example shown in Table 3.

Comparative Example 6

First heat treatment: after heat treatment at a temperature of 700°C for 1 hour, temperature ramping up from 700°C to 1000°C at a temperature ramping up rate of 3°C/minute.
Second heat treatment and temperature ramping down step: the same as second heat treatment and temperature ramping down step in Example shown in Table 3.

13) Table 13
Comparative Example 7

First heat treatment: after heat treatment at a temperature of 700°C for 1 hour, temperature ramping up from 700°C to 750°C at a temperature ramping up rate of 0.5°C/minute, temperature ramping down from 750 to 700°C at a temperature ramping down rate of 2°C/minute, taking out a wafer from a furnace at a temperature of 700°C, and cooling the wafer down to the room temperature.
Second heat treatment and temperature ramping down step: the same as second heat treatment and temperature ramping down step in Example shown in Table 7.

Comparative Example 8

First heat treatment: after heat treatment at a temperature of 700°C for 1 hour, temperature ramping up from 700°C to 800°C at a temperature ramping up rate of 2°C/minute, temperature ramping down from 800 to 700°C at a temperature ramping down rate of 2°C/minute, taking out a wafer from a furnace at a temperature of 700°C, and cooling the wafer down to the room temperature.
Second heat treatment and temperature ramping down step: the same as second heat treatment and temperature ramping down step in Example shown in Table 7.

Comparative Example 9

First Heat Treatment: after heat treatment at a temperature of 700°C for 4 hours, temperature ramping up from 700°C to 800°C at a temperature ramping up rate of 2°C/minute, temperature ramping down from 800 to 700°C at a temperature ramping down rate of 2°C/minute, taking out wafer from furnace at a temperature of 700°C, and cooling the wafer down to the room temperature.
Second heat treatment and temperature ramping down step: the same as second heat treatment and temperature ramping down step in Example shown in Table 8.

Comparative Example 10
Divisional heat treatment

First heat treatment: after heat treatment at a temperature of 700°C for 4 hours, temperature ramping up from 700°C to 750°C at a temperature ramping up rate of 0.5°C/minute, temperature ramping down from 750 to 700°C at a temperature ramping down rate of 2°C/minute, taking out a wafer from a furnace at a temperature of 700°C, and cooing the wafer down to the room temperature.

Second heat treatment and temperature ramping down step: the same as second heat treatment and temperature ramping down step in Example shown in Table 9.

In order to examine a BMD density and an interstitial oxygen concentration at a stage of a temperature of 1000°C, substrates manufactured under the same conditions were put in a batch-type vertical heat treatment furnace, and a wafer pulled from the furnace after only the first heat treatment was performed was prepared in a continuous heat treatment, while a wafer pulled from the furnace at a temperature of 1000°C after temperature rising up to 1000°C in the second heat treatment was performed was prepared in a case of a divisional heat treatment.

Measurement and Evaluation of Annealed Wafer and Epitaxial Wafer

Measurement and evaluation of annealed wafers and epitaxial wafers obtained under the abovementioned manufacturing conditions regarding the following (1), (2), (3), and (5) were conducted. Regarding a wafer added with nitrogen, (4) nitrogen concentration was also measured. Regarding wafers to which only the first heat treatment was conducted, (2) and (3) were also conducted (the result is shown in Table 2). TEM samples of samples used for measurements of (1) and (2) were collected from two portions of a central portion of each wafer and a portion spaced from an edge of the wafer by 10mm by grinding each wafer to predetermined depths ($50\mu m$, $100\mu m$, $300\mu m$) by a precise grinding machine. Measurements were conducted at a stage that focus was set to predetermined depths($50\mu m$, $100\mu m$, $300\mu m$) and a predetermined positions (the center, a position spaced from an edge of a wafer by 10mm) by utilizing OPP.

(1) Determination of BMD shape: The BMD ellipticity was determined from a ratio of signal intensities obtained by measuring the same measurement sample twice while a scanning direction of OPP was changed between <110> direction and <100> direction. That is, a relationship between the ratio of signal intensities and the BMD ellipticity was examined in advance and the ellipticity was obtained from the ratio of signal intensities. Measurement was also conducted by TEM and the ellipticity was measured from a microscope viewed from [001] direction and obtained at this time. BMD shape determination was conducted from these results. Incidentally, at least 10 BMDs were measured for each sample, an average ellipticity was obtained by averaging all ellipticities of respective samples obtained thereby, and the BMD shape determination was made based upon whether or not the average ellipticity exceeded 1.5.

(2) BMD diagonal length and density: Regarding each sample, the BMD diagonal length and density were obtained by using OPP and TEM. From the observation result of BMD obtained by the method of the following 1) and 2), a density of BMDs having predetermined diagonal length was obtained. Incidentally, as the density of BMDs having the predetermined diagonal length, an average value of values at three points was adopted.

1) Measurement using OPP: Signal intensity obtained by electrically signal-processing phase difference of transmission laser due to BMDs was measured by using OPP manufactured by AXENT Technologies Inc. A calibration curve is as follows:

Octahedral BMD diagonal length (nm) = $153 \times$ (OPP signal)$^{0.43}$
Plate-shaped BMD diagonal length (nm) = $344 \times$ (OPP signal)$^{0.52}$

BMD with a known diagonal length was measured by using OPP and a calibration curve showing a relationship between signal intensity and BMD size was prepared in advance. A diagonal length of BMD was obtained from signal intensity by using the calibration curve. Incidentally, when the diagonal length was obtained, Ghost Signal Removal Processing (K. Nakai Review of Scientific Instruments, vol. 69 (1998) pp. 3283) was conducted. Detection sensitivity was set to such sensitivity that BMD with a diagonal length of 80nm or more could be measured.

2) Measurement using TEM: A density of BMDs with a predetermined diagonal length was obtained from a microscope image obtained by measurement. Incidentally, the density was obtained from the number of BMDs observed within a field of view and a volume of a sample corresponding to an observed region.

(3) Interstitial oxygen concentrations of annealed wafer and epitaxial wafer:

The interstitial oxygen concentrations in annealed wafer and epitaxial wafer were measured by utilizing infrared absorption spectrophotometry, and values of JEITA (Japan Electronics and Information Technology Industries Association) were used as conversion factor.

(4) Nitrogen concentration of annealed wafer and epitaxial wafer:

Samples were selected from an annealed wafer and an epitaxial wafer, polish up to 20μm was conducted to the wafers in order to remove nitrogen outward diffusion layers of the surface thereof, and nitrogen concentrations in the wafers were then measured by using SIMS.

(5) Slip lengths and warpage-resistance evaluation of annealed wafer and epitaxial wafer:

After the following (5)-A was performed to an annealed wafer and an epitaxial wafer, heat treatment (hereinafter, called "simulated device process heat treatment") where (5)-B was repeated ten times was performed. Warpages of the annealed wafer and the epitaxial wafer before the heat treatment and after heat treatment were measured by using FT-90A manufactured by NIDEK Corporation. The annealed wafer after the heat treatment was observed by using X-ray topography and the maximum length of the observed slip lengths was defined as a representative value.

(5)-A: Heat treatment using a vertical furnace

(I): 780°C, 3 hours
(II): additionally, 1000°C, 8 hours

Incidentally, insertion and pulling-out were conducted at a temperature of 700°C, all the temperature rising/falling rates were 5°C/minute, and all heat treatments were conducted under argon atmosphere.

(5)-B: heat treatment using RTA
Insertion: room temperature
Temperature ramping up: 50°C/minute
Holding: 1100°C, 1 minute
Temperature ramping down: 30°C/munite
Pulling-out: room temperature
Atmosphere: argon

Each measurement result and evaluation result of annealed wafer and epitaxial wafer
In Tables 1 to 6, regarding annealed wafers and epitaxial wafers manufactured under various manufacturing conditions, densities of BMDs with predetermined diagonal lengths and interstitial oxygen concentrations measured, slips and warpage amounts generated by the pseudo device process heat treatment are collectively shown as Examples and Comparative Examples. Here, the BMD density (1) shown in Table 1, Table 2, and Table 5 is a density of plate-shaped BMDs whose diagonal lengths are in a range of 10nm to 120nm, the BMD density (2) is a density of plate-shaped BMDs whose diagonal lengths are 750nm or more, and the BMD density at a stage where the first heat treatment has been completed is a density of plate-shaped BMDs whose diagonal lengths are 5nm or more. The BMD density (1) shown in Table 3, Table 4, and Table 6 is a density of octahedral BMDs whose diagonal lengths are in a range of 10nm to 50nm, the BMD density (2) is a density of plate-shaped BMDs whose diagonal lengths are 750nm or more, and the BMD density at a stage where the first heat treatment has been completed is a density of plate-shaped BMDs whose diagonal lengths are 5nm or more. The BMD density (1) shown in Table 5 and Table 6 is a density of octahedral BMDs whose diagonal lengths are in a range of 10nm to 50nm, the BMD density (2) is a density of octahedral BMDs whose diagonal lengths are 300nm or more, and the BMD density at a stage where the first heat treatment has been completed is a density of octahedral BMDs whose diagonal lengths are 5nm or more. In Examples 2 and 4, all BMD diagonal lengths were 30nm or more, and all the BMD diagonal lengths were 20nm or more in Examples 29, 31, 47 and 49.

Incidentally, all slips of wafers and warpage amounts of wafers before warpage evaluation were 10μm or less. Nitrogen concentrations of annealed wafer and epitaxial wafer which were added with nitrogen were the same as nitrogen concentrations measured as grown.

In Table 1 to Table 13, regarding annealed wafers and epitaxial wafers manufactured under various manufacture conditions, densities of BMDs with a predetermined diagonal length and interstitial oxygen concentrations measured, and slips and warpages generated in the pseudo device process heat treatment are collectively shown as Examples and Comparative Examples.

Here, the BMD densities(1) in Tables 1, table 2, Table 7, Table 10, and in Comparative Examples 7 and 8 at Table 13 are densities of plate-shaped BMDs whose diagonal lengths are in a range of 10nm to 120nm, the BMD densities (2) are densities of plate-shaped BMDs whose diagonal lengths are 750nm or more, and the BMD densities at a stage that the first heat treatment has been completed and at a stage that a wafer has been taken out at a temperature of 1000°C at the second heat treatment in a case of the divisional heat treatment are densities of plate-shaped BMDs whose diagonal lengths are 5nm or more. Here, in Examples 2 and 4, all the BMD diagonal lengths were 30nm or more.

The BMD density (1) Tables 3 and 4, Table 8, Table 11, and in Comparative Example 9 at Table 13 is a density of octahedral BMDs whose diagonal lengths are in a range of 10nm to 50nm, the BMD density (2) is a density of plate-shaped BMDs whose diagonal lengths are 750nm or more, and the BMD densities at a stage that the first heat treatment has been completed and at a stage that a wafer has been taken out at a temperature of 1000°C at the second heat treatment in a case of the divisional heat treatment are densities of plate-shaped BMDs whose diagonal lengths are 5nm or more. Here, in Examples 29 and 31, all the BMD diagonal lengths were 20nm or more.

The BMD density (1) in Table 5 Table 6, Table 9, Table 12, and in Comparative Example 10 at Table 13 is a density of octahedral BMDs whose diagonal lengths are in a range of 10nm to 50nm, the BMD density (2) is a density of octahedral BMDs whose diagonal lengths are 300nm or more, and the BMD densities at a stage that the first heat treatment has been completed and at a stage that a wafer has been taken out at a temperature of 1000°C at the second heat treatment in a case of the divisional heat treatment are densities of plate-shaped BMDs whose diagonal lengths are 5nm or more. Here, in Examples 47 and 49, all the BMD diagonal lengths were 20nm or more.
Incidentally, all slips of wafers and warpage amounts of wafers before warpage evaluation were $10\mu$m or less. Nitrogen concentrations of annealed wafer and epitaxial wafer which were added with nitrogen were the same as nitrogen concentrations measured as grown.

From these results, it is understood that, regardless of conduction type of a silicon wafer, the plate-shaped BMD density (1) becomes $1 \times 10^{11}$/cm$^3$ or more and the plate-shaped BMD density (2) becomes $1 \times 10^7$/cm$^3$ or less, or the octahedral BMD density (1) becomes $5 \times 10^{11}$/cm$^3$ or more and the plate-shaped BMD density (2) becomes $1 \times 10^7$/cm$^3$ or less, or the octahedral BMD density (1) becomes $5 \times 10^{11}$/cm$^3$ or more and the octahedral BMD density (2) becomes $1 \times 10^7$/cm$^3$ or less, so that lengths of slips become 10mm or less and warpage amounts are suppressed to $20\mu$m or less even in annealed wafers and epitaxial wafers having respective diameters.

Further, when the plate-shaped BMD density (1) became $5 \times 10^{-11}$/cm$^3$ or more, or the octahedral BMD density (1) became $1 \times 10^{12}$/cm$^3$ or more, slips were made further small (5mm or less). When the plate-shaped BMD density (1) was $1 \times 10^{11}$/cm$^3$ or more and all the BMDs were 30nm or more, or the octahedral BMD density (1) was $5 \times 10^{11}$/cm$^3$ or more and all the BMDs were 20nm or more, slips were made further small (5mm or less).

Further, even if the plate-shaped BMD density (2) or the octahedral BMD density (2) is the same, the warpage amount is reduced to $15\mu$m or less by adding nitrogen to a substrate.

Further, from Comparative Examples, when the plate-shaped BMD density (1) was less than $1 \times 10^{11}$/cm$^3$, or the octahedral BMD density (1) was less than $5 \times 10^{11}$/cm$^3$, as a result, the slip exceeded 10mm. Regarding the silicon wafer, the density of BMDs whose diagonal lengths were 5nm or more was less than $1 \times 10^{11}$/cm$^3$ or less, or $5 \times 10^{11}$/cm$^3$ or less at the stage that the first heat treatment had been completed and at the stage that the wafer had been taken out at a temperature of 1000°C at the second heat treatment in a case of the divisional heat treatment. When the plate-shaped BMD density (2) or the octahedral BMD density (2) exceeded $1 \times 10^7$/cm$^3$, the warpage amount exceeded $20\mu$m. Regarding the silicon wafer, the interstitial oxygen concentration exceeded $5 \times 10^7$atoms/cm$^3$ at the stage that the first heat treatment had been completed and at the stage that the wafer had been taken out at a temperature of 1000°C at the second heat treatment in a case of the divisional heat treatment.

Further, under the heat treatment conditions in the Comparative Examples, when the plate-shaped BMD density (1) was $1 \times 10^{11}$/cm$^3$ or more and the plate-shaped BMD density (2) was $1 \times 10^7$/cm$^3$ or less, when the octahedral BMD density (1) was $5 \times 10^{11}$/cm$^3$ and the plate-shaped BMD density (2) was $1 \times 10^7$/cm$^3$ or less, or when the octahedral BMD density (1) was $5 \times 10^{11}$/cm$^3$ and the octahedral BMD density (2) was $1 \times 10^7$/cm$^3$ or less, the warpage exceeded $20\mu$m when the interstitial oxygen concentration exceeded $5 \times 10^{17}$atoms/cm$^3$.

In Examples, since slip and warpage resistance evaluation tests accompanying precipitation of interstitial oxygen were conducted, in the silicon wafer according to the present invention where interstitial oxygen concentration has not been reduced, an effect of slip and warpage suppression is not apparently clear. But when heat treatment (for example, heat treatment at a relatively low temperature for a short time) where heat treatment does not accompany precipitation of interstitial oxygen so much is performed, occurrence of slip and warpage can be suppressed significantly even in the silicon wafer according to the present invention
where the interstitial oxygen concentration has not been reduced.

Brief Description of the Drawings

FIG. 1 is a diagram for explaining slip and warpage introduced in RTA heat treatment.

FIG. 2 is an illustrative diagram showing discrimination between an octahedral BMD and a plate-shaped BMD.

Table 1

| No. | Wafer Diameter | Conduction Type | Nitrogen | Carbon | Oxygen | Wafer taken out at temperature of 1000 °C | | | | Interstitial Oxygen Diffusion Length at temperature ramping up step | Interstitial Oxygen Diffusion Length at second heat treatment | Annealed Wafer or Epitaxial Wafer | | | | | | Slip | Warpage Amount | Remarks |
|---|---|---|---|---|---|---|---|---|---|---|---|---|---|---|---|---|---|---|---|---|
| | | | | | | Wafer Center Portion | | 10mm from Wafer Edge | | | | Wafer Center Portion | | | 10mm from Wafer Edge | | | | | |
| | | | | | | BMD | Interstitial Oxygen | BMD | Interstitial Oxygen | | | BMD (/cm3) | | Interstitial Oxygen | BMD (/cm3) | | Interstitial Oxygen | | | |
| | mm | | atoms/cm3 | atoms/cm3 | atoms/cm3 | /cm3 | atoms/cm3 | /cm3 | atoms/cm3 | um | um | (1) | (2) | atoms/cm3 | (1) | (2) | atoms/cm3 | mm | um | |
| Example 1 | 200 | p | — | — | 8,0E+17 | 2,5E+11 | 4,1E+17 | 1,5E+11 | 4,4E+17 | 5 | 25 | 2,3E+11 | 4,3E+06 | 4,1E+17 | 1,4E+11 | 2,4E+06 | 4,4E+17 | 9,1 | 18 | |
| Example 2 | 200 | p | — | — | 9,5E+17 | 2,9E+11 | 4,1E+17 | 4,2E+11 | 4,8E+17 | 5 | 25 | 2,9E+11 | 4,4E+06 | 4,4E+17 | 3,6E+11 | 1,6E+06 | 4,6E+17 | 4,8 | 17 | All BMDs were 30 nm or more |
| Example 3 | 200 | p | — | 3,0E+15 | 8,0E+17 | 1,5E+12 | 4,3E+17 | 2,3E+12 | 2,7E+17 | 5 | 25 | 1,5E+12 | 6,0E+05 | 2,1E+17 | 2,0E+12 | 6,6E+05 | 2,6E+17 | 4,5 | 16 | |
| Example 4 | 200 | p | — | 2,0E+16 | 9,5E+17 | 4,6E+12 | 4,8E+17 | 3,8E+12 | 2,4E+17 | 5 | 25 | 3,9E+12 | 6,4E+05 | 2,9E+17 | 3,6E+12 | 7,5E+05 | 2,4E+17 | 4,6 | 15 | All BMDs were 30 nm or more |
| Example 5 | 200 | p | 5,0E+14 | — | 8,0E+17 | 4,2E+11 | 4,5E+17 | 2,0E+11 | 4,5E+17 | 5 | 25 | 3,5E+11 | 4,5E+06 | 4,3E+17 | 1,9E+11 | 3,3E+06 | 4,5E+17 | 9,4 | 13 | |
| Example 6 | 200 | p | 5,0E+14 | 3,0E+15 | 8,0E+17 | 2,4E+12 | 4,1E+17 | 2,5E+12 | 2,1E+17 | 5 | 25 | 2,3E+12 | 5,7E+05 | 2,2E+17 | 2,2E+12 | 7,6E+05 | 2,4E+17 | 4,1 | 11 | |
| Example 7 | 200 | p | 1,0E+15 | — | 8,0E+17 | 3,1E+11 | 4,7E+17 | 1,2E+11 | 4,5E+17 | 5 | 25 | 2,6E+11 | 6,6E+06 | 4,7E+17 | 1,1E+11 | 3,3E+06 | 4,8E+17 | 9,1 | 10 | |
| Example 8 | 200 | p | 1,0E+15 | 3,0E+15 | 8,0E+17 | 1,3E+12 | 4,6E+17 | 2,8E+12 | 2,2E+17 | 5 | 25 | 1,2E+12 | 5,1E+05 | 2,2E+17 | 2,3E+12 | 6,0E+05 | 2,3E+17 | 4,5 | 8 | |
| Example 9 | 300 | p | — | — | 8,0E+17 | 3,2E+11 | 3,9E+17 | 2,0E+11 | 4,7E+17 | 5 | 25 | 2,7E+11 | 5,4E+06 | 4,6E+17 | 1,9E+11 | 2,5E+06 | 4,4E+17 | 6,8 | 18 | |
| Example 10 | 300 | p | 5,0E+14 | — | 8,0E+17 | 2,6E+11 | 4,3E+17 | 3,1E+11 | 3,9E+17 | 5 | 25 | 2,3E+11 | 1,9E+06 | 4,8E+17 | 2,7E+11 | 1,5E+06 | 4,8E+17 | 9,5 | 14 | |
| Example 11 | 300 | p | 5,0E+14 | 2,0E+16 | 8,0E+17 | 4,5E+12 | 4,2E+17 | 4,9E+12 | 2,1E+17 | 5 | 25 | 4,4E+12 | 7,3E+05 | 2,1E+17 | 3,4E+12 | 6,4E+05 | 2,1E+17 | 4,4 | 11 | |
| Example 12 | 200 | n | — | — | 8,0E+17 | 1,5E+11 | 4,8E+17 | 2,0E+11 | 4,6E+17 | 5 | 25 | 1,4E+11 | 1,7E+06 | 4,5E+17 | 1,8E+11 | 4,3E+06 | 4,5E+17 | 7,1 | 18 | |
| Example 13 | 200 | n | 1,0E+15 | — | 8,0E+17 | 1,7E+11 | 4,5E+17 | 2,8E+11 | 4,4E+17 | 5 | 25 | 1,5E+11 | 4,5E+06 | 4,1E+17 | 2,8E+11 | 3,8E+06 | 4,7E+17 | 6,9 | 9 | |
| Example 14 | 200 | n | 1,0E+15 | 2,0E+16 | 8,0E+17 | 3,4E+12 | 4,0E+17 | 4,0E+12 | 2,1E+17 | 5 | 25 | 3,1E+12 | 6,5E+05 | 2,5E+17 | 3,8E+12 | 7,7E+05 | 2,6E+17 | 4,8 | 7 | |
| Example 15 | 300 | n | — | — | 8,0E+17 | 2,4E+11 | 4,0E+17 | 1,8E+11 | 4,4E+17 | 5 | 25 | 2,2E+11 | 5,4E+06 | 4,6E+17 | 1,8E+11 | 4,4E+06 | 4,5E+17 | 9,2 | 17 | |
| Example 16 | 300 | n | 1,0E+15 | — | 8,0E+17 | 2,4E+11 | 4,5E+17 | 2,1E+11 | 4,4E+17 | 5 | 25 | 2,1E+11 | 2,4E+06 | 4,8E+17 | 1,8E+11 | 5,2E+06 | 4,4E+17 | 9,1 | 9 | |
| Example 17 | 300 | n | 1,0E+15 | 2,0E+16 | 8,0E+17 | 4,4E+12 | 4,7E+17 | 3,4E+12 | 2,6E+17 | 5 | 25 | 4,3E+12 | 5,2E+05 | 2,7E+17 | 3,3E+12 | 6,4E+05 | 2,5E+17 | 4,6 | 6 | |

Table 2

| No. | Wafer Diameter | Conduction Type | Nitrogen | Carbon | Oxygen | Wafer taken out at temperature of 1000 °C | | | | Interstitial Oxygen Diffusion Length at temperature ramping up step | Interstitial Oxygen Diffusion Length at second heat treatment | Annealed Wafer or Epitaxial Wafer | | | | | | Slip | Warpage Amount | Remarks |
|---|---|---|---|---|---|---|---|---|---|---|---|---|---|---|---|---|---|---|---|---|
| | | | | | | Wafer Center Portion | | 10mm from Wafer Edge | | | | Wafer Center Portion | | | 10mm from Wafer Edge | | | | | |
| | | | | | | BMD | Interstitial Oxygen | BMD | Interstitial Oxygen | | | BMD (/cm3) | | Interstitial Oxygen | BMD (/cm3) | | Interstitial Oxygen | | | |
| | mm | | atoms/cm3 | atoms/cm3 | atoms/cm3 | /cm3 | atoms/cm3 | /cm3 | atoms/cm3 | um | um | (1) | (2) | atoms/cm3 | (1) | (2) | atoms/cm3 | mm | um | |
| Example 18 | 200 | p | — | — | 8,0E+17 | 2,8E+11 | 4,8E+17 | 4,0E+11 | 4,1E+17 | 5 | 25 | 2,30E+11 | 4,70E+06 | 4,40E+17 | 3,80E+11 | 2,20E+06 | 4,70E+17 | 7,2 | 17 | |
| Example 19 | 200 | p | 1,0E+15 | — | 8,0E+17 | 2,8E+11 | 4,0E+17 | 1,4E+11 | 4,4E+17 | 5 | 25 | 2,60E+11 | 5,40E+06 | 4,70E+17 | 1,30E+11 | 4,60E+06 | 4,30E+17 | 7,3 | 10 | |
| Example 20 | 200 | p | 1,0E+15 | 3,0E+15 | 8,0E+17 | 2,6E+12 | 4,3E+17 | 2,9E+12 | 2,9E+17 | 5 | 25 | 2,20E+12 | 4,90E+06 | 2,80E+17 | 2,80E+12 | 5,20E+05 | 2,50E+17 | 4,5 | 7 | |
| Example 21 | 300 | p | — | — | 8,0E+17 | 2,6E+11 | 4,1E+17 | 2,2E+11 | 4,5E+17 | 5 | 25 | 2,40E+11 | 6,40E+06 | 4,10E+17 | 2,20E+11 | 5,00E+08 | 4,00E+17 | 9,2 | 18 | |
| Example 22 | 200 | n | — | — | 8,0E+17 | 1,3E+11 | 4,0E+17 | 1,7E+11 | 4,0E+17 | 5 | 25 | 1,10E+11 | 4,20E+06 | 4,40E+17 | 1,60E+11 | 2,90E+06 | 4,00E+17 | 8,6 | 16 | |
| Example 23 | 200 | n | 1,0E+15 | — | 8,0E+17 | 3,0E+11 | 4,1E+17 | 2,6E+11 | 3,9E+17 | 5 | 25 | 2,80E+11 | 5,30E+06 | 4,50E+17 | 2,60E+11 | 6,50E+06 | 4,60E+17 | 9 | 9 | |
| Example 24 | 200 | n | 1,0E+15 | 2,0E+16 | 8,0E+17 | 3,3E+12 | 4,3E+17 | 3,8E+12 | 2,0E+17 | 5 | 25 | 3,30E+12 | 6,00E+05 | 2,70E+17 | 3,60E+12 | 6,20E+05 | 2,60E+17 | 4,5 | 7 | |
| Example 25 | 300 | n | — | — | 8,0E+17 | 3,5E+11 | 4,3E+17 | 4,2E+11 | 4,3E+17 | 5 | 25 | 3,20E+11 | 1,90E+06 | 4,00E+17 | 3,70E+11 | 4,90E+06 | 4,10E+17 | 8,3 | 18 | |
| Example 26 | 300 | n | 1,0E+15 | — | 8,0E+17 | 4,1E+11 | 3,9E+17 | 3,8E+11 | 4,0E+17 | 5 | 25 | 3,50E+11 | 2,20E+06 | 4,30E+17 | 3,30E+11 | 1,10E+06 | 4,40E+17 | 9,7 | 9 | |
| Example 27 | 300 | n | 1,0E+15 | 2,0E+16 | 8,0E+17 | 4,0E+12 | 4,1E+17 | 3,8E+12 | 2,8E+17 | 5 | 25 | 3,60E+12 | 6,60E+05 | 2,80E+17 | 3,40E+12 | 6,50E+05 | 2,70E+17 | 4,8 | 6 | |

Table 3

| No. | Wafer Diameter | Conduction Type | Nitrogen | Carbon | Oxygen | Wafer taken out at temperature of 1000 °C | | | | Interstitial Oxygen Diffusion Length at temperature ramping up step | Interstitial Oxygen Diffusion Length at second heat treatment | Annealed Wafer or Epitaxial Wafer | | | | | | Slip | Warpage Amount | Remarks |
|---|---|---|---|---|---|---|---|---|---|---|---|---|---|---|---|---|---|---|---|---|
| | | | | | | Wafer Center Portion | | 10mm from Wafer Edge | | | | Wafer Center Portion | | | 10mm from Wafer Edge | | | | | |
| | mm | | atoms/cm3 | atoms/cm3 | atoms/cm3 | BMD | Interstitial | BMD | Interstitial Oxygen | | | BMD (/cm3) | | Interstitial Oxygen | BMD (/cm3) | | Interstitial Oxygen | mm | um | |
| | | | | | | /cm3 | atoms/cm3 | /cm3 | atoms/cm3 | um | um | (1) | (2) | atoms/cm3 | (1) | (2) | atoms/cm3 | | | |
| Example 28 | 200 | p | 5,0E+14 | — | 8,0E+17 | 8,6E+11 | 3,9E+17 | 6,3E+11 | 4,0E+17 | 5 | 35 | 8,3E+11 | 1,5E+06 | 3,9E+17 | 6,1E+11 | 6,6E+06 | 4,8E+17 | 8,8 | 15 | |
| Example 29 | 200 | p | 5,0E+14 | — | 9,5E+17 | 7,5E+11 | 4,3E+17 | 6,5E+11 | 4,8E+17 | 5 | 35 | 6,3E+11 | 3,0E+06 | 4,4E+17 | 6,4E+11 | 3,3E+06 | 4,5E+17 | 4,6 | 14 | All BMDs were 20 nm or more |
| Example 30 | 200 | p | 5,0E+14 | 3,00E+15 | 8,0E+17 | 1,6E+12 | 4,2E+17 | 4,0E+12 | 2,8E+17 | 5 | 35 | 1,4E+12 | 5,1E+05 | 2,2E+17 | 3,9E+12 | 5,6E+05 | 2,5E+17 | 4 | 11 | |
| Example 31 | 200 | p | 5,0E+14 | 3,00E+15 | 9,5E+17 | 1,4E+12 | 4,5E+17 | 4,4E+12 | 2,9E+17 | 5 | 35 | 1,4E+12 | 5,9E+05 | 2,1E+17 | 4,3E+12 | 6,4E+05 | 2,1E+17 | 4,2 | 12 | All BMDs were 20 nm or more |
| Example 32 | 200 | p | 1,0E+15 | — | 8,0E+17 | 7,7E+11 | 4,1E+17 | 6,8E+11 | 4,1E+17 | 5 | 35 | 7,4E+11 | 6,1E+06 | 4,1E+17 | 6,1E+11 | 2,1E+06 | 4,5E+17 | 8,4 | 9 | |
| Example 33 | 200 | p | 1,0E+15 | 3,00E+15 | 8,0E+17 | 2,2E+12 | 4,0E+17 | 3,3E+12 | 2,1E+17 | 5 | 35 | 2,0E+12 | 7,5E+05 | 2,5E+17 | 3,2E+12 | 7,1E+05 | 2,0E+17 | 3,9 | 6 | |
| Example 34 | 300 | p | 5,0E+14 | — | 8,0E+17 | 9,2E+11 | 4,3E+17 | 6,8E+11 | 4,6E+17 | 5 | 35 | 8,5E+11 | 5,3E+06 | 3,9E+17 | 6,5E+11 | 5,9E+06 | 4,8E+17 | 9 | 14 | |
| Example 35 | 300 | p | 5,0E+14 | 2,00E+16 | 8,0E+17 | 4,9E+12 | 4,0E+17 | 3,1E+12 | 2,7E+17 | 5 | 35 | 4,7E+12 | 5,3E+05 | 2,6E+17 | 3,0E+12 | 6,9E+05 | 2,5E+17 | 4,7 | 11 | |
| Example 36 | 200 | n | 1,0E+15 | — | 8,0E+17 | 7,3E+11 | 4,3E+17 | 6,5E+11 | 3,9E+17 | 5 | 35 | 6,8E+11 | 4,7E+06 | 4,3E+17 | 5,8E+11 | 5,4E+06 | 4,8E+17 | 8,5 | 8 | |
| Example 37 | 200 | n | 1,0E+15 | 2,00E+16 | 8,0E+17 | 4,4E+12 | 4,2E+17 | 3,8E+12 | 2,4E+17 | 5 | 35 | 3,9E+12 | 5,9E+05 | 2,9E+17 | 3,5E+12 | 4,9E+05 | 2,9E+17 | 4,7 | 6 | |
| Example 38 | 300 | n | 1,0E+15 | — | 8,0E+17 | 8,3E+11 | 4,1E+17 | 6,7E+11 | 4,6E+17 | 5 | 35 | 7,2E+11 | 6,1E+06 | 4,0E+17 | 6,5E+11 | 5,5E+06 | 4,3E+17 | 9,1 | 9 | |
| Example 39 | 300 | n | 1,0E+15 | 2,00E+16 | 8,0E+17 | 3,5E+12 | 4,5E+17 | 4,9E+12 | 2,2E+17 | 5 | 35 | 3,4E+12 | 6,4E+05 | 2,8E+17 | 4,2E+12 | 7,7E+05 | 2,8E+17 | 4,5 | 5 | |

Table 4

| No. | Wafer Diameter | Conduction Type | Nitrogen | Carbon | Oxygen | Wafer taken out at temperature of 1000 °C | | | | Interstitial Oxygen Diffusion Length at temperature ramping up step | Interstitial Oxygen Diffusion Length at second heat treatment | Annealed Wafer or Epitaxial Wafer | | | | | | Slip | Warpage Amount | Remarks |
|---|---|---|---|---|---|---|---|---|---|---|---|---|---|---|---|---|---|---|---|---|
| | | | | | | Wafer Center Portion | | 10mm from Wafer Edge | | | | Wafer Center Portion | | | 10mm from Wafer Edge | | | | | |
| | mm | | atoms/cm3 | atoms/cm3 | atoms/cm3 | BMD | Interstitial | BMD | Interstitial Oxygen | | | BMD (/cm3) | | Interstitial Oxygen | BMD (/cm3) | | Interstitial Oxygen | mm | um | |
| | | | | | | /cm3 | atoms/cm3 | /cm3 | atoms/cm3 | um | um | (1) | (2) | atoms/cm3 | (1) | (2) | atoms/cm3 | | | |
| Example 40 | 200 | p | 1,0E+15 | — | 8,0E+17 | 8,2E+11 | 4,3E+17 | 6,3E+11 | 4,2E+17 | 5 | 35 | 8,1E+11 | 4,1E+06 | 4,2E+17 | 5,8E+11 | 4,2E+06 | 4,2E+17 | 8,8 | 9 | |
| Example 41 | 200 | p | 1,0E+15 | 3,0E+15 | 8,0E+17 | 2,3E+12 | 4,3E+17 | 4,1E+12 | 2,1E+17 | 5 | 35 | 2,1E+12 | 6,9E+05 | 2,5E+17 | 4,0E+12 | 7,0E+05 | 2,5E+17 | 4,6 | 7 | |
| Example 42 | 200 | n | 1,0E+15 | — | 8,0E+17 | 7,4E+11 | 4,1E+17 | 6,6E+11 | 4,7E+17 | 5 | 35 | 7,0E+11 | 4,1E+06 | 4,6E+17 | 6,0E+11 | 6,1E+06 | 4,5E+17 | 7,3 | 10 | |
| Example 43 | 200 | n | 1,0E+15 | 2,0E+16 | 8,0E+17 | 4,3E+12 | 3,9E+17 | 4,9E+12 | 2,8E+17 | 5 | 35 | 4,0E+12 | 5,2E+05 | 2,3E+17 | 4,1E+12 | 6,0E+05 | 2,3E+17 | 4,1 | 5 | |
| Example 44 | 300 | n | 1,0E+15 | — | 8,0E+17 | 8,3E+11 | 3,9E+17 | 7,6E+11 | 4,5E+17 | 5 | 35 | 7,7E+11 | 6,0E+06 | 4,2E+17 | 6,5E+11 | 3,2E+06 | 3,9E+17 | 7,3 | 8 | |
| Example 45 | 300 | n | 1,0E+15 | 2,0E+16 | 8,0E+17 | 4,9E+12 | 4,7E+17 | 4,9E+12 | 2,9E+17 | 5 | 35 | 4,7E+12 | 7,4E+05 | 2,8E+17 | 4,8E+12 | 5,1E+05 | 2,5E+17 | 4 | 7 | |

Table 5

| No. | Wafer Diameter mm | Conduction Type | Nitrogen atoms/cm3 | Carbon atoms/cm3 | Oxygen atoms/cm3 | Wafer taken out at temperature of 1000 °C | | | | Interstitial Oxygen Diffusion Length at temperature ramping up step um | Interstitial Oxygen Diffusion Length at second heat treatment um | Annealed Wafer or Epitaxial Wafer | | | | | | Slip mm | Warpage Amount um | Remarks |
|---|---|---|---|---|---|---|---|---|---|---|---|---|---|---|---|---|---|---|---|---|
| | | | | | | Wafer Center Portion | | 10mm from Wafer Edge | | | | Wafer Center Portion | | | 10mm from Wafer Edge | | | | | |
| | | | | | | BMD /cm3 | Interstitial atoms/cm3 | BMD /cm3 | Interstitial Oxygen atoms/cm3 | | | BMD (/cm3) (1) | (2) | Interstitial Oxygen atoms/cm3 | BMD (/cm3) (1) | (2) | Interstitial Oxygen atoms/cm3 | | | |
| Example 46 | 200 | p | --- | --- | 8,00E+17 | 1,00E+12 | 4,70E+17 | 6,40E+11 | 4,80E+17 | 5 | 35 | 8,30E+11 | 2,60E+06 | 4,60E+17 | 6,50E+11 | 4,20E+06 | 3,90E+17 | 8,1 | 19 | |
| Example 47 | 200 | p | --- | --- | 9,00E+17 | 5,30E+11 | 3,90E+17 | 5,10E+11 | 4,30E+17 | 5 | 35 | 5,20E+11 | 3,30E+06 | 4,10E+17 | 5,10E+11 | 1,10E+06 | 4,40E+17 | 4,5 | 19 | All BMDs were 20 nm or more |
| Example 48 | 200 | p | --- | 3,00E+15 | 8,00E+17 | 2,10E+12 | 4,80E+17 | 3,60E+12 | 2,10E+17 | 5 | 35 | 2,00E+12 | 6,00E+05 | 2,20E+17 | 3,40E+12 | 4,90E+05 | 2,60E+17 | 3,9 | 16 | |
| Example 49 | 200 | p | --- | 2,00E+16 | 9,00E+17 | 3,50E+12 | 4,10E+17 | 4,60E+12 | 2,30E+17 | 5 | 35 | 3,10E+12 | 5,60E+05 | 2,00E+17 | 4,70E+12 | 5,20E+05 | 2,40E+17 | 4,3 | 17 | All BMDs were 20 nm or more |
| Example 50 | 300 | p | --- | --- | 8,00E+17 | 8,40E+11 | 3,90E+17 | 5,40E+11 | 4,40E+17 | 5 | 35 | 8,30E+11 | 1,70E+06 | 4,30E+17 | 5,10E+11 | 1,70E+06 | 4,40E+17 | 7,4 | 18 | |
| Example 51 | 300 | p | --- | 2,00E+16 | 8,00E+17 | 3,40E+12 | 4,20E+17 | 3,60E+12 | 2,50E+17 | 5 | 35 | 3,60E+12 | 7,30E+05 | 2,60E+17 | 3,60E+12 | 7,70E+05 | 2,10E+17 | 4,3 | 16 | |
| Example 52 | 200 | n | --- | --- | 8,00E+17 | 5,60E+11 | 4,50E+17 | 5,90E+11 | 4,20E+17 | 5 | 35 | 5,40E+11 | 5,60E+06 | 3,90E+17 | 5,30E+11 | 3,10E+06 | 4,30E+17 | 9,2 | 18 | |
| Example 53 | 200 | n | --- | 2,00E+16 | 8,00E+17 | 4,50E+12 | 4,40E+17 | 4,60E+12 | 2,80E+17 | 5 | 35 | 4,40E+12 | 6,30E+05 | 2,40E+17 | 4,60E+12 | 7,60E+05 | 2,50E+17 | 4,7 | 16 | |
| Example 54 | 300 | n | --- | --- | 8,00E+17 | 7,20E+11 | 4,50E+17 | 5,60E+11 | 4,30E+17 | 5 | 35 | 7,40E+11 | 5,30E+06 | 4,60E+17 | 5,30E+11 | 2,30E+06 | 4,00E+17 | 6,6 | 19 | |
| Example 55 | 300 | n | --- | 2,00E+16 | 8,00E+17 | 4,10E+12 | 4,80E+17 | 4,30E+12 | 2,60E+17 | 5 | 35 | 4,00E+12 | 7,60E+05 | 2,70E+17 | 4,30E+12 | 5,80E+05 | 2,70E+17 | 4,5 | 16 | |

Table 6

| No. | Wafer Diameter mm | Conduction Type | Nitrogen atoms/cm3 | Carbon atoms/cm3 | Oxygen atoms/cm3 | After first heat treatment | | | | Interstitial Oxygen Diffusion Length at temperature ramping up step um | Interstitial Oxygen Diffusion Length at second heat treatment um | Annealed Wafer or Epitaxial Wafer | | | | | | Slip mm | Warpage Amount um | Remarks |
|---|---|---|---|---|---|---|---|---|---|---|---|---|---|---|---|---|---|---|---|---|
| | | | | | | Wafer Center Portion | | 10mm from Wafer Edge | | | | Wafer Center Portion | | | 10mm from Wafer Edge | | | | | |
| | | | | | | BMD /cm3 | Interstitial atoms/cm3 | BMD /cm3 | Interstitial Oxygen atoms/cm3 | | | BMD (/cm3) (1) | (2) | Interstitial Oxygen atoms/cm3 | BMD (/cm3) (1) | (2) | Interstitial Oxygen atoms/cm3 | | | |
| Example 56 | 200 | p | --- | --- | 8,0E+17 | 8,0E+11 | 4,5E+17 | 8,4E+11 | 3,9E+17 | 5 | 35 | 6,2E+11 | 3,9E+06 | 4,4E+17 | 6,7E+11 | 3,4E+06 | 4,6E+17 | 6,6 | 18 | |
| Example 57 | 200 | p | --- | 2,0E+16 | 8,0E+17 | 3,6E+12 | 2,3E+17 | 3,8E+12 | 2,6E+17 | 5 | 35 | 3,6E+12 | 5,3E+05 | 2,4E+17 | 2,9E+12 | 6,6E+05 | 2,5E+17 | 4,7 | 16 | |
| Example 58 | 300 | p | --- | --- | 8,0E+17 | 7,4E+11 | 4,6E+17 | 6,3E+11 | 4,2E+17 | 5 | 35 | 7,2E+11 | 5,9E+06 | 4,6E+17 | 5,3E+11 | 4,6E+06 | 4,5E+17 | 8,5 | 17 | |
| Example 59 | 300 | p | --- | 2,0E+16 | 8,0E+17 | 4,1E+12 | 2,2E+17 | 3,8E+12 | 2,5E+17 | 5 | 35 | 3,6E+12 | 5,0E+05 | 2,7E+17 | 3,3E+12 | 5,5E+05 | 2,8E+17 | 4,6 | 16 | |
| Example 60 | 200 | n | --- | --- | 8,0E+17 | 6,1E+11 | 4,6E+17 | 7,9E+11 | 4,1E+17 | 5 | 35 | 5,5E+11 | 6,3E+06 | 4,2E+17 | 6,1E+11 | 5,4E+06 | 4,2E+17 | 8,6 | 19 | |
| Example 61 | 200 | n | --- | 2,0E+16 | 8,0E+17 | 4,6E+12 | 2,7E+17 | 4,6E+12 | 2,8E+17 | 5 | 35 | 3,6E+12 | 5,4E+05 | 2,3E+17 | 4,6E+12 | 6,5E+05 | 2,3E+17 | 4,1 | 15 | |
| Example 62 | 300 | n | --- | --- | 8,0E+17 | 1,2E+12 | 4,5E+17 | 7,0E+11 | 4,6E+17 | 5 | 35 | 8,3E+11 | 6,7E+06 | 4,6E+17 | 5,8E+11 | 5,1E+06 | 4,6E+17 | 6,6 | 17 | |
| Example 63 | 300 | n | --- | 2,0E+16 | 8,0E+17 | 4,6E+12 | 2,5E+17 | 4,1E+12 | 2,6E+17 | 5 | 35 | 3,7E+12 | 6,2E+05 | 2,3E+17 | 3,6E+12 | 5,5E+05 | 2,5E+17 | 4,6 | 15 | |

Table 7

| No. | Wafer Diameter mm | Conduction Type | Nitrogen atoms/cm3 | Carbon atoms/cm3 | Oxygen atoms/cm3 | Wafer taken out at temperature of 1000 °C | | | | Interstitial Oxygen Diffusion Length at second heat treatment um | Annealed Wafer or Epitaxial Wafer | | | | | | Slip mm | Warpage Amount um |
|---|---|---|---|---|---|---|---|---|---|---|---|---|---|---|---|---|---|---|
| | | | | | | Wafer Center Portion | | 10mm from Wafer Edge | | | Wafer Center Portion | | | 10mm from Wafer Edge | | | | |
| | | | | | | BMD /cm3 | Interstitial Oxygen atoms/cm3 | BMD /cm3 | Interstitial Oxygen atoms/cm3 | | BMD (/cm3) (1) | (2) | Interstitial Oxygen atoms/cm3 | BMD (/cm3) (1) | (2) | Interstitial Oxygen atoms/cm3 | | |
| Example 64 | 200 | p | — | — | 8.0E+17 | 2.5E+11 | 3.7E+17 | 1.6E+11 | 4.0E+17 | 25 | 2.3E+11 | 4.3E+08 | 4.1E+17 | 1.4E+11 | 2.4E+08 | 4.4E+17 | 9.1 | 18 |
| Example 65 | 200 | p | — | 3.0E+15 | 8.0E+17 | 1.6E+12 | 1.9E+17 | 2.2E+12 | 2.3E+17 | 25 | 1.5E+12 | 6.0E+05 | 2.1E+17 | 2.0E+12 | 6.6E+05 | 2.6E+17 | 4.5 | 15 |
| Example 66 | 200 | p | — | 2.0E+16 | 9.5E+17 | 4.3E+12 | 2.6E+17 | 4.0E+12 | 2.2E+17 | 25 | 3.9E+12 | 6.4E+05 | 2.9E+17 | 3.6E+12 | 7.5E+05 | 2.4E+17 | 4.6 | 16 |
| Example 67 | 200 | p | 1.0E+15 | — | 8.0E+17 | 2.9E+11 | 4.2E+17 | 1.2E+11 | 4.3E+17 | 25 | 2.6E+11 | 6.6E+08 | 4.7E+17 | 1.1E+11 | 3.3E+08 | 4.8E+17 | 9.1 | 10 |
| Example 68 | 200 | p | 1.0E+15 | 3.0E+15 | 8.0E+17 | 1.3E+12 | 2.0E+17 | 2.6E+12 | 2.1E+17 | 25 | 1.2E+12 | 5.1E+05 | 2.2E+17 | 2.3E+12 | 6.0E+05 | 2.3E+17 | 4.5 | 7 |

Table 8

| No. | Wafer Diameter mm | Conduction Type | Nitrogen atoms/cm3 | Carbon atoms/cm3 | Oxygen atoms/cm3 | Wafer taken out at temperature of 1000 °C | | | | Interstitial Oxygen Diffusion Length at second heat treatment um | Annealed Wafer or Epitaxial Wafer | | | | | | Slip mm | Warpage Amount um | Remarks |
|---|---|---|---|---|---|---|---|---|---|---|---|---|---|---|---|---|---|---|---|
| | | | | | | Wafer Center Portion | | 10mm from Wafer Edge | | | Wafer Center Portion | | | 10mm from Wafer Edge | | | | | |
| | | | | | | BMD /cm3 | Interstitial Oxygen atoms/cm3 | BMD /cm3 | Interstitial Oxygen atoms/cm3 | | BMD (/cm3) (1) | (2) | Interstitial Oxygen atoms/cm3 | BMD (/cm3) (1) | (2) | Interstitial Oxygen atoms/cm3 | | | |
| Example 69 | 200 | p | 5.0E+14 | — | 8.0E+17 | 9.1E+11 | 3.5E+17 | 8.7E+11 | 4.3E+17 | 35 | 8.3E+11 | 1.5E+08 | 3.9E+17 | 6.1E+11 | 6.6E+08 | 4.8E+17 | 8.8 | 19 | |
| Example 70 | 200 | p | 5.0E+14 | 3.0E+15 | 8.0E+17 | 1.6E+12 | 2.0E+17 | 4.3E+12 | 2.2E+17 | 35 | 1.4E+12 | 5.1E+05 | 2.2E+17 | 3.9E+12 | 5.6E+05 | 2.5E+17 | 4 | 13 | |
| Example 71 | 200 | p | 5.0E+14 | 3.0E+15 | 9.5E+17 | 1.6E+12 | 1.9E+17 | 4.8E+12 | 1.9E+17 | 35 | 1.4E+12 | 5.9E+05 | 2.1E+17 | 4.3E+12 | 6.4E+05 | 2.1E+17 | 4.2 | 14 | |
| Example 72 | 200 | p | 1.0E+15 | — | 8.0E+17 | 8.1E+11 | 3.7E+17 | 6.7E+11 | 4.0E+17 | 35 | 7.4E+11 | 6.1E+06 | 4.1E+17 | 6.1E+11 | 2.1E+06 | 4.5E+17 | 8.4 | 8 | |
| Example 73 | 200 | p | 1.0E+15 | 3.0E+15 | 8.0E+17 | 2.2E+12 | 2.2E+17 | 3.5E+12 | 1.8E+17 | 35 | 2.0E+12 | 7.5E+05 | 2.5E+17 | 3.2E+12 | 7.1E+05 | 2.0E+17 | 3.9 | 6 | |

Table 9

| No. | Wafer Diameter mm | Conduction Type | Nitrogen atoms/cm3 | Carbon atoms/cm3 | Oxygen atoms/cm3 | Wafer taken out at temperature of 1000 °C | | | | Interstitial Oxygen Diffusion Length at second heat treatment um | Annealed Wafer or Epitaxial Wafer | | | | | | Slip mm | Warpage Amount um | Remarks |
|---|---|---|---|---|---|---|---|---|---|---|---|---|---|---|---|---|---|---|---|
| | | | | | | Wafer Center Portion | | 10mm from Wafer Edge | | | Wafer Center Portion | | | 10mm from Wafer Edge | | | | | |
| | | | | | | BMD /cm3 | Interstitial Oxygen atoms/cm3 | BMD /cm3 | Interstitial Oxygen atoms/cm3 | | BMD (/cm3) (1) | (2) | Interstitial Oxygen atoms/cm3 | BMD (/cm3) (1) | (2) | Interstitial Oxygen atoms/cm3 | | | |
| Example 74 | 200 | p | — | — | 8.0E+17 | 8.3E+11 | 4.4E+17 | 7.3E+11 | 3.7E+17 | 35 | 7.5E+11 | 2.7E+08 | 4.9E+17 | 6.7E+11 | 4.4E+08 | 4.1E+17 | 8.6 | 19 | |
| Example 75 | 200 | p | — | — | 9.0E+17 | 9.0E+11 | 3.9E+17 | 5.5E+11 | 4.1E+17 | 35 | 8.2E+11 | 3.4E+08 | 4.3E+17 | 5.0E+11 | 1.2E+06 | 4.6E+17 | 7.2 | 18 | |
| Example 76 | 200 | p | — | 3.0E+15 | 9.0E+17 | 2.3E+12 | 2.1E+17 | 3.8E+12 | 2.4E+17 | 35 | 2.1E+12 | 6.3E+05 | 2.3E+17 | 3.5E+12 | 5.1E+05 | 2.7E+17 | 4.1 | 17 | |

Table10

| No. | Wafer Diameter mm | Conduction Type | Nitrogen atoms/cm3 | Carbon atoms/cm3 | Oxygen atoms/cm3 | Wafer taken out at temperature of 1000 ℃ | | | | Interstitial Oxygen Diffusion Length at temperature ramping up step um | Interstitial Oxygen Diffusion Length at second heat treatment um | Annealed Wafer or Epitaxial Wafer | | | | | | Slip mm | Warpage Amount um | Remarks |
| | | | | | | Wafer Center Portion | | 10mm from Wafer Edge | | | | Wafer Center Portion | | | 10mm from Wafer Edge | | | | | |
| | | | | | | BMD /cm3 | Interstitial atoms/cm3 | BMD /cm3 | Interstitial Oxygen atoms/cm3 | | | BMD (/cm3) | | Interstitial Oxygen atoms/cm3 | BMD (/cm3) | | Interstitial Oxygen atoms/cm3 | | | |
| | | | | | | | | | | | | (1) | (2) | | (1) | (2) | | | | |
| Comparative Example 1 | 200 | p | --- | --- | 8,0E+17 | 6,5E+10 | 4,6E+17 | 6,3E+10 | 4,4E+17 | 5 | 25 | 5,8E+10 | 5,6E+08 | 3,9E+17 | 5,3E+10 | 6,6E+08 | 4,1E+17 | 16,6 | 18 | |
| Comparative Example 2 | 200 | p | 5,0E+14 | 3,0E+15 | 8,0E+17 | 2,8E+11 | 6,3E+17 | 4,2E+11 | 6,0E+17 | 3 | 25 | 2,6E+11 | 5,8E+07 | 4,1E+17 | 3,1E+11 | 5,8E+07 | 4,7E+17 | 7 | 25 | |
| Comparative Example 3 | 200 | p | --- | --- | 1,2E+18 | 6,4E+11 | 6,5E+17 | 7,0E+11 | 6,8E+17 | 3 | 12 | 5,2E+11 | 2,5E+08 | 6,3E+17 | 6,7E+11 | 4,1E+08 | 5,5E+17 | 7,4 | 25 | |

Table 11

| No. | Wafer Diameter mm | Conduction Type | Nitrogen atoms/cm3 | Carbon atoms/cm3 | Oxygen atoms/cm3 | Wafer taken out at temperature of 1000 ℃ | | | | Interstitial Oxygen Diffusion Length at temperature ramping up step um | Interstitial Oxygen Diffusion Length at second heat treatment um | Annealed Wafer or Epitaxial Wafer | | | | | | Slip mm | Warpage Amount um | Remarks |
| | | | | | | Wafer Center Portion | | 10mm from Wafer Edge | | | | Wafer Center Portion | | | 10mm from Wafer Edge | | | | | |
| | | | | | | BMD /cm3 | Interstitial atoms/cm3 | BMD /cm3 | Interstitial Oxygen atoms/cm3 | | | BMD (/cm3) | | Interstitial Oxygen atoms/cm3 | BMD (/cm3) | | Interstitial Oxygen atoms/cm3 | | | |
| | | | | | | | | | | | | (1) | (2) | | (1) | (2) | | | | |
| Comparative Example 4 | 200 | p | 1,0E+14 | 3,0E+15 | 8,0E+17 | 1,0E+12 | 6,3E+17 | 8,5E+11 | 6,0E+17 | 3 | 35 | 8,1E+11 | 5,8E+07 | 4,7E+17 | 7,4E+11 | 5,8E+07 | 4,1E+17 | 9,3 | 20 | |

Table 12

| No. | Wafer Diameter mm | Conduction Type | Nitrogen atoms/cm3 | Carbon atoms/cm3 | Oxygen atoms/cm3 | Wafer taken out at temperature of 1000 °C | | | | Interstitial Oxygen Diffusion Length at temperature ramping up step um | Interstitial Oxygen Diffusion Length at second heat treatment um | Annealed Wafer or Epitaxial Wafer | | | | | | Slip mm | Warpage Amount um | Remarks |
|---|---|---|---|---|---|---|---|---|---|---|---|---|---|---|---|---|---|---|---|---|
| | | | | | | Wafer Center Portion | | 10mm from Wafer Edge | | | | Wafer Center Portion | | | 10mm from Wafer Edge | | | | | |
| | | | | | | BMD /cm3 | Interstitial Oxygen atoms/cm3 | BMD /cm3 | Interstitial Oxygen atoms/cm3 | | | BMD (/cm3) (1) | (2) | Interstitial Oxygen atoms/cm3 | BMD (/cm3) (1) | (2) | Interstitial Oxygen atoms/cm3 | | | |
| Comparative Example 5 | 200 | p | — | — | 8,0E+17 | 7,4E+10 | 4,6E+17 | 9,2E+10 | 4,0E+17 | 5 | 35 | 5,3E+10 | 5,8E+06 | 4,6E+17 | 8,4E+10 | 5,8E+06 | 4,4E+17 | 15,2 | 18 | |
| Comparative Example 6 | 200 | p | — | — | 1,0E+18 | 7,0E+11 | 6,5E+17 | 7,6E+11 | 6,8E+17 | 3 | 35 | 5,7E+11 | 1,9E+06 | 6,2E+17 | 5,6E+11 | 1,5E+06 | 5,8E+17 | 8,5 | 24 | |

Table 13

| No. | Wafer Diameter mm | Conduction Type | Nitrogen atoms/cm3 | Carbon atoms/cm3 | Oxygen atoms/cm3 | Wafer taken out at temperature of 1000 °C | | | | Interstitial Oxygen Diffusion Length at second heat treatment um | Annealed Wafer or Epitaxial Wafer | | | | | | | Slip mm | Warpage Amount um | Remarks |
|---|---|---|---|---|---|---|---|---|---|---|---|---|---|---|---|---|---|---|---|---|
| | | | | | | Wafer Center Portion | | 10mm from Wafer Edge | | | Wafer Center Portion | | | 10mm from Wafer Edge | | | | | |
| | | | | | | BMD /cm3 | Interstitial atoms/cm3 | BMD /cm3 | Interstitial Oxygen atoms/cm3 | | BMD (/cm3) (1) | (2) | Interstitial Oxygen atoms/cm3 | BMD (/cm3) (1) | (2) | Interstitial Oxygen atoms/cm3 | | | |
| Comparative Example 7 | 200 | p | — | — | 8,0E+17 | 6,6E+10 | 5,0E+17 | 7,8E+10 | 6,1E+17 | 25 | 6,0E+10 | 2,1E+07 | 5,6E+17 | 7,1E+10 | 4,2E+07 | 6,8E+17 | 12 | 25 | |
| Comparative Example 8 | 200 | p | 1,0E+14 | 3,0E+15 | 8,0E+17 | 7,7E+10 | 5,8E+17 | 8,9E+10 | 6,7E+17 | 25 | 7,0E+10 | 3,2E+07 | 6,4E+17 | 8,1E+10 | 4,1E+07 | 7,4E+17 | 14,2 | 26 | |
| Comparative Example 9 | 200 | p | 1,0E+14 | 3,0E+15 | 8,0E+17 | 3,5E+10 | 5,6E+17 | 3,1E+10 | 6,4E+17 | 35 | 3,2E+10 | 6,8E+07 | 6,2E+17 | 2,8E+10 | 5,6E+10 | 7,1E+17 | 13,1 | 28 | |
| Comparative Example 10 | 200 | p | — | — | 8,0E+17 | 2,1E+11 | 7,4E+17 | 3,4E+11 | 6,1E+17 | 35 | 1,2E+11 | 2,1E+11 | 6,1E+17 | 1,3E+11 | 2,3E+07 | 5,6E+17 | 14,1 | 25 | |

**Claims**

1. A silicon wafer where a shape of BMDs is octahedral, wherein
   a density of BMDs whose diagonal lengths are in a range of 10nm to 50nm, of BMDs present at a deep position which is inwardly spaced from a surface of a silicon wafer by a distance of 50 $\mu$m or more, is $5 \times 10^{11}$/cm$^3$ or more, a density of BMDs whose diagonal lengths are 300nm or more, of BMDs present at a deep position which is inwardly spaced from a surface of a silicon wafer by a distance of 50 $\mu$m or more, is $1 \times 10^7$/cm$^3$ or less, and the interstitial oxygen concentration is $5 \times 10^{17}$ atoms/cm$^3$ or less.

2. A silicon wafer where plate-shaped BMDs and octahedral BMDs are present, wherein
   a density of octahedral BMDs whose diagonal lengths are in a range of 10nm to 50nm, of BMDs present at a deep position which is inwardly spaced from a surface of a silicon wafer by a distance of 50 $\mu$m or more, is $5 \times 10^{11}$/cm$^3$ or more,
   a density of plate-shaped BMDs whose diagonal lengths are 750nm or more, of BMDs present at a deep position which is inwardly spaced from a surface of a silicon wafer by a distance of 50 $\mu$m or more, are $1 \times 10^7$/cm$^3$ or less, and the interstitial oxygen concentration is $5 \times 10^{17}$ atoms/cm$^3$ or less.

3. A silicon wafer where a shape of BMDs is plate-shaped, wherein
   a density of BMDs whose diagonal lengths are in a range of 10nm to 120nm, of BMDs present at a deep position which is spaced inwardly from a surface of a silicon wafer by a distance of 50 $\mu$m or more, is $1 \times 10^{11}$/cm$^3$ or more, a density of BMDs whose diagonal lengths are 750nm or more, of BMDs present at a deep position which is spaced inwardly from a surface of a silicon wafer by a distance of 50 $\mu$m or more, is $1 \times 10^7$/cm$^3$ or less, and the interstitial oxygen concentration is $5 \times 10^{17}$ atoms/cm$^3$ or less.

4. A method for manufacturing the silicon wafer according to claim 1, wherein a heat treatment is performed, the heat treatment including the following steps:

   (A) a low temperature heat treatment step conducted at a temperature of 600 to 750°C for 30 minutes to 10 hours;
   (B) a step of temperature ramping up to 1000°C conducted at a temperature ramping up rate of 0.1 to 1°C/minute for 5 to 50 hours; and
   (C) a high temperature heat treatment step conducted at a temperature of 1000°C to 1250°C for such a time that the diffusion length of interstitial oxygen is in a range of 30 $\mu$m to 50 $\mu$m, where this diffusion length in $\mu$m is given by $2 \times 10^4 \times (D \times$ time [second]$)^{0.5}$, where D [cm$^2$/second] $= 0.17 \times \exp(-2.53/(8.62 \times 10^{-5}$ x Temperature [K]).

5. A method for manufacturing the silicon wafer according to claim 1, wherein a heat treatment is performed, the heat treatment including the following steps:

   (A) a step of performing a heat treatment at a temperature between 600 and 750°C for 30 minutes to 10 hours as a low temperature heat treatment step;
   (B) a step including temperature ramping up to 800°C at a temperature ramping up rate of 0.1 to 1°C/minute for 1 to 20 hours as a temperature ramping up step after the low temperature heat treatment step;
   (C) a step including ramping down the furnace temperature at a temperature ramping down rate of 1 to 10°C/minute, taking out a substrate outside furnace at the furnace temperature between 600°C to 800°C and cooling the substrate down to the room temperature ;and
   (D) a step including taking a substrate inside the furnace at the furnace temperature between 600°C to 800°C and ramping up to 1000°C at a temperature ramping up rate of 1 to 10°C/minute and performing a heat treatment at a temperature of 1000°C to 1250°C for such a time that the diffusion length of interstitial oxygen is in a range of 30 $\mu$m to 50 $\mu$m as a high temperature heat treatment step, where this diffusion length in $\mu$m is given by $2 \times 10^4 \times (D \times$ time [second]$)^{0.5}$, with D [cm$^2$/second] $= 0.17 \times \exp(-2.53/(8.62 \times 10^{-5}$ x Temperature [K]).

6. A method for manufacturing the silicon wafer according to claim 2, wherein
   a nitrogen concentration in a substrate is in a range of $5 \times 10^{14}$ atoms/cm$^3$ to $1 \times 10^{16}$ atoms/cm$^3$, and
   a heat treatment is performed on the substrate, the heat treatment including the following steps:

   (A) a low temperature heat treatment step conducted at a temperature of 600 to 750°C for 30 minutes to 10 hours;
   (B) a step including temperature ramping up conducted up to 1000°C at a temperature rising rate of 0.1 to 1°C/minute for 5 to 50 hours; and

(C) a high temperature heat treatment step performed at a temperature of 1000°C to 1250°C for such a time that the diffusion length of interstitial oxygen is in a range of 30 $\mu$m to 50 $\mu$m, where this diffusion length in $\mu$m is given by $2 \times 10^4 \times$ (D $\times$ time [second])$^{0.5}$, where D [cm$^2$/second] = 0.17 $\times$ exp (-2.53/(8.62 $\times$ 10$^{-5}$ x Temperature [K]).

7.  A method for manufacturing the silicon wafer according to claim 2, wherein
    a nitrogen concentration in a substrate is in a range of $5 \times 10^{14}$atoms/cm$^3$ to $1 \times 10^{16}$atoms/cm$^3$, and
    a heat treatment is performed to the substrate, the heat treatment including the following steps:

    (A) a step of performing a heat treatment at a temperature of 600°C to 750°C for 30 minutes to 10 hours as a low temperature heat treatment step;
    (B) a step including temperature ramping up to 800°C at a temperature ramping up rate of 0.1 to 1°C/minute for 1 to 20 hours;
    (C) a step including ramping down the furnace temperature at a temperature ramping down rate of 1 to 10°C/minute, taking out a substrate outside furnace at the furnace temperature between 600°C to 800°C and cooling the substrate down to the room temperature ;and
    (D) a step including taking a substrate inside the furnace at the furnace temperature between 600°C to 800°C and ramping up to 1000°C at a temperature ramping up rate of 1 to 10°C/minute and performing a heat treatment at a temperature of 1000°C to 1250°C for such a time that the diffusion length of interstitial oxygen is in a range of 30 $\mu$m to 50 $\mu$m as a high temperature heat treatment step, where this diffusion length in $\mu$m is given by $2 \times 10^4 \times$ (D $\times$ time [second])$^{0.5}$, with D [cm$^2$/second] = 0.17 $\times$ exp (-2.53/(8.62 $\times$ 10$^{-5}$ x Temperature [K]).

8.  A method for manufacturing the silicon wafer according to claim 3, wherein
    a heat treatment is performed on a substrate, the heat treatment including the following steps:

    (A) a low temperature heat treatment step for performing a heat treatment at a temperature of 600°C to 750°C for 10 minutes to 10 hours;
    (B) a temperature ramping up step including a step of performing temperature ramping up to 1000°C at a rate of 0.1°C/munite to 1C°/minute for 5 to 50 hours; and
    (C) a high temperature heat treatment step conducted at a temperature of 1000°C to 1250°C for such a time that the diffusion length of interstitial oxygen is in a range of 20 $\mu$m to 30 $\mu$m, where this diffusion length in $\mu$m is given by $2 \times 10^4 \times$ (D $\times$ time [second])$^{0.5}$, with D [cm$^2$/second] = 0.17 $\times$ exp (-2.53/(8.62 $\times$ 10$^{-5}$ x Temperature [K]).

9.  A method for manufacturing a silicon wafer according to claim 3, wherein
    a heat treatment is performed to a substrate, the heat treatment including the following steps:

    (A) a step of conducting heat treatment at a temperature of 600°C to 750°C for 10 minutes to 10 hours as a low temperature heat treatment step;
    (B) a step including temperature ramping up to 800°C at a temperature rising rate of 0.1 to 1°C/minute for 1 to 20 hours as a temperature rising step after the low temperature heat treatment step;
    (C) a step including ramping down the furnace temperature at a temperature ramping down rate of 1 to 10°C/minute, taking out a substrate outside furnace at the furnace temperature between 600°C to 800°C and cooling the substrate down to the room temperature ;and
    (D) a step including taking a substrate inside the furnace at the furnace temperature between 600°C to 800°C and ramping up to 1000°C at a temperature ramping up rate of 1 to 10°C/minute and performing a heat treatment at a temperature of 1000°C to 1250°C for such a time that the diffusion length of interstitial oxygen is in a range of 20 $\mu$m to 30 $\mu$m as a high temperature heat treatment step, where this diffusion length in $\mu$m is given by $2 \times 10^4 \times$ (D $\times$ time [second])$^{0.5}$, with D [cm$^2$/second] = 0.17 $\times$ exp (-2.53/(8.62 $\times$ 10$^{-5}$ x Temperature [K]).

10. The method for manufacturing a silicon wafer according to claim 8 or 9, wherein
    a nitrogen concentration in the substrate is in a range of $5 \times 10^{14}$ atoms/cm$^3$ to $1 \times 10^{16}$atoms/cm$^3$.

11. The method for manufacturing a silicon wafer according to any one of claims 4 to 8 or 9, wherein
    a carbon concentration in the substrate is in a range of $2 \times 10^{15}$atoms/cm$^3$ to $3 \times 10^{16}$ atoms/cm$^3$.

**Patentansprüche**

1. Silizium-Wafer, wobei eine Gestalt von BMDs oktaedrisch ist, wobei
eine Dichte von BMDs, deren Diagonallängen in einem Bereich von 10 nm bis 50 nm liegen, von BMDs, die an einer tiefen Position vorliegen, die von einer Oberfläche eines Silizium-Wafer mit einer Distanz von 50 $\mu$m oder mehr nach innen beabstandet ist, $5 \times 10^{11}/cm^3$ oder mehr beträgt,
eine Dichte von BMDs, deren Diagonallängen 300 nm oder mehr betragen, von BMDs, die an einer tiefen Position vorliegen, die von einer Oberfläche eines Silizium-Wafer mit einer Distanz von 50 $\mu$m oder mehr nach innen beabstandet ist, $1 \times 10^7/cm^3$ oder weniger beträgt, und
die Zwischengittersauerstoffkonzentration $5 \times 10^{17}$ Atome/$cm^3$ oder weniger beträgt.

2. Silizium-Wafer, wobei plättchenförmige BMDs und oktaedrische BMDs vorliegen, wobei
eine Dichte von oktaedrischen BMDs, deren Diagonallängen in einem Bereich von 10 nm bis 50 nm liegen, von BMDs, die an einer tiefen Position vorliegen, die von einer Oberfläche eines Silizium-Wafer mit einer Distanz von 50 $\mu$m oder mehr nach innen beabstandet ist, $5 \times 10^{11}/cm^3$ oder mehr beträgt,
eine Dichte von plättchenförmigen BMDs, deren Diagonallängen 750 nm oder mehr betragen, von BMDs, die an einer tiefen Position vorliegen, die von einer Oberfläche eines Silizium-Wafer mit einer Distanz von 50 $\mu$m oder mehr nach innen beabstandet ist, $1 \times 10^7/cm^3$ oder weniger beträgt, und
die Zwischengittersauerstoffkonzentration $5 \times 10^{17}$ Atome/$cm^3$ oder weniger beträgt.

3. Silizium-Wafer, wobei eine Gestalt von BMDs plättchenförmig ist, wobei
eine Dichte von BMDs, deren Diagonallängen in einem Bereich von 10 nm bis 120 nm liegen, von BMDs, die an einer tiefen Position vorliegen, die von einer Oberfläche eines Silizium-Wafer mit einer Distanz von 50 $\mu$m oder mehr nach innen beabstandet ist, $1 \times 10^{11}/cm^3$ oder mehr beträgt,
eine Dichte von BMDs, deren Diagonallängen 750 nm oder mehr betragen, von BMDs, die an einer tiefen Position vorliegen, die von einer Oberfläche eines Silizium-Wafer mit einer Distanz von 50 $\mu$m oder mehr nach innen beabstandet ist, $1 \times 10^7/cm^3$ oder weniger beträgt, und
die Zwischengittersauerstoffkonzentration $5 \times 10^{17}$ Atome/$cm^3$ oder weniger beträgt.

4. Verfahren zum Herstellen des Silizium-Wafer nach Anspruch 1, wobei eine Wärmebehandlung durchgeführt wird, wobei die Wärmebehandlung die folgenden Schritte beinhaltet:

   (A) einen Niedertemperaturwärmebehandlungsschritt, der bei einer Temperatur von 600°C bis 750°C für 30 Minuten bis 10 Stunden durchgeführt wird;
   (B) einen Schritt des Temperaturerhöhens bis zu 1000°C, der bei einer Temperaturerhöhungsrate von 0,1 bis 1°C/Minute für 5 bis 50 Stunden durchgeführt wird; und
   (C) einen Hochtemperaturwärmebehandlungsschritt, der bei einer Temperatur von 1000°C bis 1250°C für eine derartige Zeit durchgeführt wird, dass die Diffusionslänge von Zwischengittersauerstoff in einem Bereich von 30 $\mu$m bis 50 $\mu$m liegt, wobei diese Diffusionslänge in $\mu$m gegeben ist durch $2 \times 10^4 \times (D \times \text{Zeit [Sekunden]})^{0,5}$, wobei $D$ [$cm^2$/Sekunde] $= 0,17 \times \exp(-2,53/(8,62 \times 10^{-5} \times \text{Temperatur [K]})$ ist.

5. Verfahren zum Herstellen des Silizium-Wafer nach Anspruch 1, wobei eine Wärmebehandlung durchgeführt wird, wobei die Wärmebehandlung die folgenden Schritte beinhaltet:

   (A) einen Schritt des Ausführens einer Wärmebehandlung bei einer Temperatur zwischen 600°C und 750°C für 30 Minuten bis 10 Stunden als ein Niedertemperaturwärmebehandlungsschritt;
   (B) einen Schritt mit Temperaturerhöhung bis zu 800°C bei einer Temperaturerhöhungsrate von 0,1 bis 1°C/Minute für 1 bis 20 Stunden als ein Temperaturerhöhungsschritt nach dem Niedertemperaturwärmebehandlungsschritt;
   (C) einen Schritt mit Senkung der Ofentemperatur bei einer Temperatursenkungsrate von 1 bis 10°C/Minute, Herausnehmen eines Substrats aus dem Ofen bei der Ofentemperatur zwischen 600°C und 800°C und Abkühlen des Substrats auf die Raumtemperatur; und
   (D) einen Schritt mit dem Nehmen eines Substrats innerhalb des Ofens bei der Ofentemperatur zwischen 600°C und 800°C und Erhöhen auf 1000°C mit einer Temperaturerhöhungsrate von 1 bis 10°C/Minute und Durchführen einer Wärmebehandlung bei einer Temperatur von 1000°C bis 1250°C für eine derartige Zeit, dass die Diffusionslänge von Zwischengittersauerstoff in einem Bereich von 30 $\mu$m bis 50 $\mu$m als ein Hochtemperaturwärmebehandlungsschritt liegt, wobei diese Diffusionslänge in $\mu$m gegeben ist durch $2 \times 10^4 \times (D \times \text{Zeit [Sekunden]})^{0,5}$, wobei $D$ [$cm^2$/Sekunde] $= 0,17 \times \exp(-2,53/(8,62 \times 10^{-5} \times \text{Temperatur [K]})$ ist.

6. Verfahren zum Herstellen des Silizium-Wafer nach Anspruch 2, wobei
eine Stickstoffkonzentration in einem Substrat in einem Bereich von 5 x $10^{14}$ Atome/cm$^3$ bis 1 x $10^{16}$ Atome/cm$^3$ liegt, und
eine Wärmebehandlung an dem Substrat durchgeführt wird, wobei die Wärmebehandlung die folgenden Schritte beinhaltet:

(A) einen Niedertemperaturwärmebehandlungsschritt, der bei einer Temperatur von 600°C bis 750°C für 30 Minuten bis 10 Stunden durchgeführt wird;
(B) einen Schritt mit Temperaturerhöhung, durchgeführt bis zu 1000°C bei einer Temperaturanstiegsrate von 0,1 bis 1°C/Minute für 5 bis 50 Stunden; und
(C) einen Hochtemperaturwärmebehandlungsschritt, der bei einer Temperatur von 1000°C bis 1250°C für eine derartige Zeit ausgeführt wird, dass die Diffusionslänge von Zwischengittersauerstoff in einem Bereich von 30 $\mu$m bis 50 $\mu$m liegt, wobei diese Diffusionslänge in $\mu$m gegeben ist durch 2 x $10^4$ x (D x Zeit [Sekunden])$^{0,5}$, wobei D [cm$^2$/Sekunde] = 0,17 x exp (-2,53/(8,62 x $10^{-5}$ x Temperatur [K]) ist.

7. Verfahren zum Herstellen des Silizium-Wafer nach Anspruch 2, wobei
eine Stickstoffkonzentration in einem Substrat in einem Bereich von 5 x $10^{14}$ Atome/cm$^3$ bis 1 x $10^{16}$ Atome/cm$^3$ liegt, und
eine Wärmebehandlung an dem Substrat durchgeführt wird, wobei die Wärmebehandlung die folgenden Schritte beinhaltet:

(A) einen Schritt des Ausführens einer Wärmebehandlung bei einer Temperatur von 600°C bis 750°C für 30 Minuten bis 10 Stunden als ein Niedertemperaturwärmebehandlungsschritt;
(B) einen Schritt mit Temperaturerhöhung bis zu 800°C bei einer Temperaturerhöhungsrate von 0,1 bis 1°C/Minute für 1 bis 20 Stunden;
(C) einen Schritt mit Senkung der Ofentemperatur bei einer Temperatursenkungsrate von 1 bis 10°C/Minute, Herausnehmen eines Substrats aus dem Ofen bei der Ofentemperatur zwischen 600°C bis 800°C und Abkühlen des Substrats auf die Raumtemperatur; und
(D) einen Schritt mit dem Nehmen eines Substrats innerhalb des Ofens bei der Ofentemperatur zwischen 600°C und 800°C und Erhöhen auf 1000°C mit einer Temperaturerhöhungsrate von 1 bis 10°C/Minute und Durchführen einer Wärmebehandlung bei einer Temperatur von 1000°C bis 1250°C für eine derartige Zeit, dass die Diffusionslänge von Zwischengittersauerstoff in einem Bereich von 30 $\mu$m bis 50 $\mu$m als ein Hochtemperaturwärmebehandlungsschritt liegt, wobei diese Diffusionslänge in $\mu$m gegeben ist durch 2 x $10^4$ x (D x Zeit [Sekunden])$^{0,5}$, wobei D [cm$^2$/Sekunde] = 0,17 x exp (-2,53/(8,62 x $10^{-5}$ x Temperatur [K]) ist.

8. Verfahren zum Herstellen des Silizium-Wafer nach Anspruch 3, wobei
eine Wärmebehandlung an einem Substrat durchgeführt wird, wobei die Wärmebehandlung die folgenden Schritte beinhaltet:

(A) einen Niedertemperaturwärmebehandlungsschritt zum Durchführen einer Wärmebehandlung bei einer Temperatur von 600°C bis 750°C für 10 Minuten bis 10 Stunden;
(B) einen Temperaturerhöhungsschritt mit einem Schritt des Durchführens einer Temperaturerhöhung bis zu 1000°C mit einer Rate von 0,1 bis 1°C/Minute für 5 bis 50 Stunden; und
(C) einen Hochtemperaturwärmebehandlungsschritt, der bei einer Temperatur von 1000°C bis 1250°C für eine derartige Zeit durchgeführt wird, dass die Diffusionslänge von Zwischengittersauerstoff in einem Bereich von 20 $\mu$m bis 30 $\mu$m liegt, wobei diese Diffusionslänge in $\mu$m gegeben ist durch 2 x $10^4$ x (D x Zeit [Sekunden])$^{0,5}$, wobei D [cm$^2$/Sekunde] = 0,17 x exp (-2,53/(8,62 x $10^{-5}$ x Temperatur [K]) ist.

9. Verfahren zum Herstellen des Silizium-Wafer nach Anspruch 3, wobei eine Wärmebehandlung an einem Substrat durchgeführt wird, wobei die Wärmebehandlung die folgenden Schritte beinhaltet:

(A) einen Schritt des Ausführens einer Wärmebehandlung bei einer Temperatur von 600°C bis 750°C für 10 Minuten bis 10 Stunden als ein Niedertemperaturwärmebehandlungsschritt;
(B) einen Schritt mit Temperaturerhöhung bis zu 800°C bei einer Temperaturanstiegsrate von 0,1 bis 1°C/Minute für 1 bis 20 Stunden als ein Temperaturanstiegsschritt nach dem Niedertemperaturwärmebehandlungsschritt;
(C) einen Schritt mit Senkung der Ofentemperatur bei einer Temperatursenkungsrate von 1 bis 10°C/Minute, Herausnehmen eines Substrats aus dem Ofen bei der Ofentemperatur zwischen 600°C und 800°C und Abkühlen des Substrats auf die Raumtemperatur; und

(D)einen Schritt mit dem Nehmen eines Substrats innerhalb des Ofens bei der Ofentemperatur zwischen 600°C und 800°C und Erhöhen auf 1000°C mit einer Temperaturerhöhungsrate von 1 bis 10°C/Minute und Durchführen einer Wärmebehandlung bei einer Temperatur von 1000°C bis 1250°C für eine derartige Zeit, dass die Diffusionslänge von Zwischengittersauerstoff in einem Bereich von 20 $\mu$m bis 30 $\mu$m als ein Hochtemperaturwärmebehandlungsschritt liegt, wobei diese Diffusionslänge in $\mu$m gegeben ist durch 2 x $10^4$ x (D x Zeit [Sekunden])$^{0,5}$, wobei D [cm$^2$/Sekunde] = 0,17 x exp (-2,53/(8,62 x $10^{-5}$ x Temperatur [K]) ist.

10. Verfahren zum Herstellen eines Silizium-Wafer nach Anspruch 8 oder 9, wobei eine Stickstoffkonzentration in einem Substrat in einem Bereich von 5 x $10^{14}$ Atome/cm$^3$ bis 1 x $10^{16}$ Atome/cm$^3$ liegt.

11. Verfahren zum Herstellen eines Silizium-Wafer nach einem der Ansprüche 4 bis 8 oder 9, wobei eine Kohlenstoffkonzentration in dem Substrat in einem Bereich von 2 x $10^{15}$ Atome/cm$^3$ bis 3 x $10^{16}$ Atome/cm$^3$ liegt.

## Revendications

1. Tranche de silicium où la forme des microdéfauts volumiques (BMD) est octaédrique, dans laquelle
la densité de BMD dont les longueurs diagonales se situent dans une gamme de 10 nm à 50 nm, parmi les BMD présents à une position en profondeur qui est écartée vers l'intérieur d'une surface de la tranche de silicium d'une distance de 50 $\mu$m ou plus, est de 5.10$^{11}$/cm$^3$ ou plus,
la densité de BMD dont les longueurs diagonales sont de 300 nm ou plus, parmi les BMD présents à une position en profondeur qui est écartée vers l'intérieur d'une surface de la tranche de silicium d'une distance de 50 $\mu$m ou plus, est de 1.10$^7$/cm$^3$ ou moins, et
la concentration d'oxygène interstitiel est de 5.10$^{17}$ atomes/cm$^3$ ou moins.

2. Tranche de silicium où des BMD en forme de plaque et des BMD octaédriques sont présents, dans laquelle
la densité de BMD octaédriques dont les longueurs diagonales se situent dans une gamme de 10 nm à 50 nm, parmi les BMD présents à une position en profondeur qui est écartée vers l'intérieur d'une surface de la tranche de silicium d'une distance de 50 $\mu$m ou plus, est de 5.10$^{11}$/cm$^3$ ou plus,
la densité de BMD en forme de plaque dont les longueurs diagonales sont de 750 nm ou plus, parmi les BMD présents à une position en profondeur qui est écartée vers l'intérieur d'une surface de la tranche de silicium d'une distance de 50 $\mu$m ou plus, est de 1.10$^7$/cm$^3$ ou moins, et
la concentration d'oxygène interstitiel est de 5.10$^{17}$ atomes/cm$^3$ ou moins.

3. Tranche de silicium où la forme des BMD est une plaque, dans laquelle
la densité de BMD dont les longueurs diagonales se situent dans une gamme de 10 nm à 120 nm, parmi les BMD présents à une position en profondeur qui est écartée vers l'intérieur d'une surface de la tranche de silicium d'une distance de 50 $\mu$m ou plus, est de 1.10$^{11}$/cm$^3$ ou plus,
la densité de BMD dont les longueurs diagonales sont de 750 nm ou plus, parmi les BMD présents à une position en profondeur qui est écartée vers l'intérieur d'une surface de la tranche de silicium d'une distance de 50 $\mu$m ou plus, est de 1.10$^7$/cm$^3$ ou moins, et
la concentration d'oxygène interstitiel est de 5.10$^{17}$ atomes/cm$^3$ ou moins.

4. Procédé pour fabriquer la tranche de silicium selon la revendication 1, dans lequel un traitement thermique est effectué, le traitement thermique comprenant les étapes suivantes :

(A) une étape de traitement thermique à basse température exécutée à une température de 600 à 750°C pendant 30 minutes à 10 heures ;
(B) une étape de montée en température jusqu'à 1000°C exécutée à une vitesse de montée en température de 0,1 à 1°C/minute pendant 5 à 50 heures ; et
(C) une étape de traitement thermique à haute température exécutée à une température de 1000°C à 1250°C pendant un temps tel que la longueur de diffusion de l'oxygène interstitiel se situe dans une gamme de 30 $\mu$m à 50 $\mu$m, où cette longueur de diffusion en $\mu$m est donnée par 2.10$^4$ x (D x temps [secondes])$^{0,5}$, où D [cm$^2$/s] = 0,17 x exp (-2,53/(8,62.10$^{-5}$ x température [K]).

5. Procédé pour fabriquer la tranche de silicium selon la revendication 1, dans lequel un traitement thermique est effectué, le traitement thermique comprenant les étapes suivantes :

(A) une étape consistant à réaliser un traitement thermique à une température comprise entre 600 et 750°C pendant 30 minutes à 10 heures en tant qu'étape de traitement thermique à basse température ;

(B) une étape comprenant une montée en température jusqu'à 800°C à une vitesse de montée en température de 0,1 à 1°C/minute pendant 1 à 20 heures en tant qu'étape de montée en température après l'étape de traitement thermique à basse température ;

(C) une étape comprenant une descente en température du four à une vitesse de descente en température de 1 à 10°C/minute, la sortie du substrat du four à une température de four comprise entre 600°C et 800°C et le refroidissement du substrat jusqu'à la température ambiante ; et

(D) une étape comprenant l'introduction du substrat à l'intérieur du four à une température de four comprise entre 600°C et 800°C, une montée jusqu'à 1000°C à une vitesse de montée en température de 1 à 10°C/minute et la réalisation d'un traitement thermique à une température de 1000°C à 1250°C pendant un temps tel que la longueur de diffusion de l'oxygène interstitiel se situe dans une gamme de 30 $\mu$m à 50 $\mu$m en tant qu'étape de traitement thermique à haute température, où cette longueur de diffusion en $\mu$m est donnée par $2.10^4$ x (D x temps [secondes])$^{0,5}$, avec D [cm$^2$/s] - 0,17 x exp(-2,53/(8,62.10$^{-5}$ x température [K]).

6. Procédé pour fabriquer la tranche de silicium selon la revendication 2, dans lequel la concentration d'azote dans un substrat se situe dans une gamme de $5.10^{14}$ atomes/cm$^3$ à $1.10^{16}$ atomes/cm$^3$, et un traitement thermique est effectué sur le substrat, le traitement thermique comprenant les étapes suivantes :

(A) une étape de traitement thermique à basse température exécutée à une température de 600 à 750°C pendant 30 minutes à 10 heures ;

(B) une étape comprenant une montée en température exécutée jusqu'à 1000°C à une vitesse de montée en température de 0,1 à 1°C/minute pendant 5 à 50 heures ; et

(C) une étape de traitement thermique à haute température exécutée à une température de 1000°C à 1250°C pendant un temps tel que la longueur de diffusion de l'oxygène interstitiel se situe dans une gamme de 30 $\mu$m à 50 $\mu$m, où cette longueur de diffusion en $\mu$m est donnée par $2.10^4$ x (D x temps [secondes])$^{0,5}$, où D [cm$^2$/s] = 0,17 x exp (-2,53/(8,62.10$^{-5}$ x température [K]).

7. Procédé pour fabriquer la tranche de silicium selon la revendication 2, dans lequel la concentration d'azote dans un substrat se situe dans une gamme de $5.10^{14}$ atomes/cm$^3$ à $1.10^{16}$ atomes/cm$^3$, et un traitement thermique est effectué sur le substrat, le traitement thermique comprenant les étapes suivantes :

(A) une étape consistant à réaliser un traitement thermique à une température de 600°C à 750°C pendant 30 minutes à 10 heures en tant qu'étape de traitement thermique à basse température ;

(B) une étape comprenant une montée en température jusqu'à 800°C à une vitesse de montée en température de 0,1 à 1°C/minute pendant 1 à 20 heures ;

(C) une étape comprenant une descente en température du four à une vitesse de descente en température de 1 à 10°C/minute, la sortie du substrat du four à une température de four comprise entre 600°C et 800°C et le refroidissement du substrat jusqu'à la température ambiante ; et

(D) une étape comprenant l'introduction du substrat à l'intérieur du four à une température de four comprise entre 600°C et 800°C, une montée jusqu'à 1000°C à une vitesse de montée en température de 1 à 10°C/minute et la réalisation d'un traitement thermique à une température de 1000°C à 1250°C pendant un temps tel que la longueur de diffusion de l'oxygène interstitiel se situe dans une gamme de 30 $\mu$m à 50 $\mu$m en tant qu'étape de traitement thermique à haute température, où cette longueur de diffusion en $\mu$m est donnée par $2.10^4$ x (D x temps [secondes])$^{0,5}$, avec D [cm$^2$/s] = 0,17 x exp(-2,53/(8,62.10$^{-5}$ x température [K]).

8. Procédé pour fabriquer la tranche de silicium selon la revendication 3, dans lequel un traitement thermique est effectué sur un substrat, le traitement thermique comprenant les étapes suivantes :

(A) une étape de traitement thermique à basse température pour effectuer un traitement thermique à une température de 6.00°C à 750°C pendant 10 minutes à 10 heures ;

(B) une étape de montée en température comprenant une étape consistant à réaliser une montée en température jusqu'à 1000°C à une vitesse de 0,1°C/minute à 1°C/minute pendant 5 à 50 heures ; et

(C) une étape de traitement thermique à haute température exécutée à une température de 1000°C à 1250°C pendant un temps tel que la longueur de diffusion de l'oxygène interstitiel se situe dans une gamme de 20 $\mu$m à 30 $\mu$m, où cette longueur de diffusion en $\mu$m est donnée par $2.10^4$ x (D x temps [secondes])$^{0,5}$, avec D [cm$^2$/s] = 0,17 x exp(-2,53/(8,62.10$^{-5}$ x température [K]).

**9.** Procédé pour fabriquer la tranche de silicium selon la revendication 3, dans lequel
un traitement thermique est effectué sur un substrat, le traitement thermique comprenant les étapes suivantes :

(A) une étape consistant à réaliser un traitement thermique à une température de 600 à 750°C pendant 10 minutes à 10 heures en tant qu'étape de traitement thermique à basse température ;
(B) une étape comprenant une montée en température jusqu'à 800°C à une vitesse de montée en température de 0,1 à 1°C/minute pendant 1 à 20 heures en tant qu'étape de montée en température après l'étape de traitement thermique à basse température ;
(C) une étape comprenant une descente en température du four à une vitesse de descente en température de 1 à 10°C/minute, la sortie du substrat du four à une température de four comprise entre 600°C et 800°C et le refroidissement du substrat jusqu'à la température ambiante ; et
(D) une étape comprenant l'introduction du substrat à l'intérieur du four à une température de four comprise entre 600°C et 800°C, une montée jusqu'à 1000°C à une vitesse de montée en température de 1 à 10°C/minute et la réalisation d'un traitement thermique à une température de 1000°C à 1250°C pendant un temps tel que la longueur de diffusion de l'oxygène interstitiel se situe dans une gamme de 20 $\mu$m à 30 $\mu$m en tant qu'étape de traitement thermique à haute température, où cette longueur de diffusion en $\mu$m est donnée par $2.10^4$ x (D x temps [secondes])$^{0,5}$, avec D [cm$^2$/s] - 0,17 x exp(-2,53/(8,62.10$^{-5}$ x température [K]).

**10.** Procédé pour fabriquer une tranche de silicium selon la revendication 8 ou 9, dans lequel
la concentration d'azote dans le substrat se situe dans une gamme de $5.10^{14}$ atomes/cm$^3$ à $1.10^{16}$ atomes/cm$^3$.

**11.** Procédé pour fabriquer une tranche de silicium selon l'une quelconque des revendications 4 à 8 ou 9, dans lequel
la concentration de carbone dans le substrat se situe dans une gamme de $2.10^{15}$ atomes/cm$^3$ à $3.10^{16}$ atomes/cm$^3$.

# Slip

# Warpage

**Fig. 1**

EP 1 928 016 B1

# Fig. 2

## (1)

111
111
[001]
[010]
[100]

B
A
[010]
[001] [100]

## (2)

100
111
[001]
[010] 111
[100]
100

B
A
[010]
[001] [100]

## (3)

111
[001]
[010] 111
[100]

B
A
[010]
[001] [100]

## (4)

111
[001]
[010] 111
[100]
100

B
A
[010]
[001] [100]

## (5)

100
[001]
[010]
[100]

B
A
[010]
[001] [100]

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 10098047 A
- JP 2006040980 A
- JP 8213403 A
- WO 2006003812 A

**Non-patent literature cited in the description**

- **Sueoka et al.** Effect of Oxide Precipitate Sizes on the Mechanical Strength of Czochralski Silicon Wafers. *Japanese Journal of Applied Physics,* December 1997, vol. 36 (12A), ISSN 0021-4922, 7095-7099
- **Stavola et al.** Diffusivity of oxygen in silicon at the donor formation temperature. *Appl. Phys. Lett.,* 1983, vol. 42 (1
- **K. Nakai.** Ghost Signal Removal Processing. *Review of Scientific Instruments,* 1998, vol. 69, 3283